# EUROPEAN PATENT APPLICATION

(11) **EP 4 738 602 A1**
(43) Date of publication of application: **06.05.2026**
(21) Application number: 24843331.0
(22) Date of filing: 18.06.2024
(51) Int. Cl.: H01Q 1/24, H01Q 5/307, H01Q 1/38, H05K 1/02, H04M 1/02, H04M 1/23

(54) **ELECTRONIC DEVICE COMPRISING ANTENNA MODULE**

(30) Priority: 20.07.2023 KR 20230094500; 17.10.2023 KR 20230138874
(71) Applicant: Samsung Electronics Co., Ltd., Suwon-si, Gyeonggi-do 16677 (KR)
(72) Inventor: CHO, Sujin, Suwon-si Gyeonggi-do 16677 (KR); KIM, Youngseok, Suwon-si Gyeonggi-do 16677 (KR); KWON, Kihwan, Suwon-si Gyeonggi-do 16677 (KR); CHUN, Woosung, Suwon-si Gyeonggi-do 16677 (KR)
(74) Representative: HGF
(86) International application number: PCT/KR2024/008401
(87) International publication number: WO 2025/018610

(57) **Abstract**

The electronic device may include: a housing including a front surface, a rear surface, and a side wall; a camera assembly disposed adjacent to the side wall; a support protrusion protruding from the camera assembly in one direction; a first radiator which is disposed as at least a part of a first portion of the side wall adjacent to the camera assembly and performs wireless communication in a first frequency band; an antenna module partially disposed between the camera assembly and a second portion of the side wall, the second portion being adjacent to the first portion, the antenna module performing wireless communication in a second frequency band; and a first flexible printed circuit board which extends from the antenna module and is at least partially disposed between the first portion and the camera assembly, wherein the first flexible printed circuit board is disposed to surround or cover two regions disposed to be inclined or perpendicular to each other among surfaces of the support protrusion.

## Description

### [Technical Field]

An embodiment(s) of the disclosure relates to an electronic device, e.g., an electronic device including an antenna module.

### [Background Art]

The term "electronic device" may refer to a device that performs a specific function according to a program installed therein, such as a home appliance, an electronic scheduler, a portable multimedia player, a mobile communication terminal, a tablet PC, a video/audio device, a desktop or laptop computer, or an in-vehicle navigation system. For example, such electronic devices may output stored information in the form of sound or video. As electronic devices become highly integrated and ultra-high-speed, high-capacity wireless communication becomes commonplace, various functions may be incorporated into a single electronic device, such as a mobile communication terminal. For example, not only communication functions but also functions such as entertainment (e.g., playing games), multimedia (e.g., playing music or videos), communication and security (e.g., for mobile banking), or scheduling and electronic wallet functions are being integrated into a single electronic device.

As personal or portable communication devices such as smartphones become more widespread, users' demand for portability and convenience of use is increasing. For example, a touchscreen display may serve as a screen, i.e., an output device for visual information, and may also provide a virtual keypad that replaces a mechanical input device (e.g., a button-type input device). Accordingly, portable communication devices or electronic devices may be miniaturized while still providing the same or even enhanced usability (e.g., a larger screen). On the other hand, as flexible displays, such as foldable or rollable displays, become commercialized, the portability and convenience of use of electronic devices are expected to be further improved. An electronic device including a flexible display may be portable in a folded or rolled state of a plurality of different structures (e.g., housings), and may provide a large screen in an unfolded state, thereby improving portability and convenience of use.

The above-described information may be provided as related art for the purpose of helping understanding of the disclosure. No claim or determination is made as to whether any of the foregoing is applicable as prior art in relation to the disclosure.

### [Detailed Description of the Invention]

### [Technical Solution]

According to an embodiment of the disclosure, an electronic device may include a housing including a front surface, a rear surface facing a direction opposite to the front surface, and a side wall at least partially surrounding a space between the front surface and the rear surface, a camera assembly disposed at one edge of the space, adjacent to the side wall, a support protrusion protruding from the camera assembly in a direction, a first radiator disposed as at least a portion of a first portion of the side wall adjacent to the camera assembly and configured to perform wireless communication in a first frequency band, an antenna module at least partially disposed between a second portion of the side wall adjacent to the first portion and the camera assembly, the antenna module configured to perform wireless communication in a second frequency band, and a first flexible printed circuit board extending from the antenna module and disposed at least partially between the first portion and the camera assembly. In an embodiment, the first flexible printed circuit board may be disposed to surround or cover two areas on a surface of the support protrusion disposed to be inclined or perpendicular with respect to each other.

According to an embodiment of the disclosure, an electronic device may include a first housing, a second housing, a hinge structure configured to rotatably couple the first housing and the second housing and provide at least one folding axis A as a rotation center of the first housing or the second housing, a flexible printed circuit board disposed from an inside of the first housing across the hinge structure to an inside of the second housing, a flexible display including a first display area, a second display area, and a folding area connecting the first display area to the second display area and disposed on the hinge structure, a camera assembly disposed at one edge inside one of the first housing and the second housing, adjacent to a side wall, a first radiator as a first portion of the side wall at least partially disposed adjacent to the camera assembly and configured to perform wireless communication in a first frequency band, an antenna module including an antenna substrate at least partially disposed between a second portion of the side wall adjacent to the first portion and the camera assembly, the antenna module configured to perform wireless communication in a second frequency band, and a second radiator as at least a portion of the second portion and configured to perform wireless communication in a third frequency band. In an embodiment, the antenna module may include a first flexible printed circuit board disposed at least partially between the first portion and the camera assembly.

### [Brief Description of Drawings]

The foregoing and other aspects, configurations, and/or advantages of an embodiment of the disclosure will be more apparent from the following detailed description taken in conjunction with the accompanying drawings.
FIG. 1 is a block diagram illustrating an electronic device in a network environment according to an embodiment of the disclosure.
FIG. 2 is a view illustrating an unfolded state of an electronic device according to an embodiment of the disclosure.
FIG. 3 is a view illustrating a folded state of an electronic device according to an embodiment of the disclosure.
FIG. 4 is an exploded perspective view illustrating an electronic device according to an embodiment of the disclosure.
FIG. 5 is a view illustrating housings coupled together in an electronic device according to an embodiment of the disclosure.
FIG. 6 is a view illustrating hinge plates disposed in an electronic device according to an embodiment of the disclosure.
FIG. 7 is a view illustrating an arrangement of hinge module(s) and electronic components inside an electronic device according to an embodiment of the disclosure.
FIG. 8 is a perspective view illustrating a contact piece of an electronic device according to an embodiment of the disclosure.
FIG. 9 is a perspective view illustrating a contact piece disposed in an electronic device according to an embodiment of the disclosure.
FIG. 10 is a view illustrating a camera assembly of an electronic device according to an embodiment of the disclosure.
FIG. 11 is a perspective view illustrating a third camera among the camera assembly of FIG. 10 in an electronic device according to an embodiment of the disclosure.
FIG. 12 is a first view illustrating a circuit board of an electronic device according to an embodiment of the disclosure.
FIG. 13 is a second view illustrating a circuit board of an electronic device according to an embodiment of the disclosure.
FIG. 14 is a view illustrating the camera assembly of FIG. 11 and the circuit board of FIG. 13 disposed in a housing in an electronic device according to an embodiment of the disclosure.
FIG. 15 is a perspective view illustrating an antenna module of an electronic device according to an embodiment of the disclosure.
FIG. 16 is a perspective view illustrating a process of disposing the antenna module of FIG. 15 in a housing in an electronic device according to an embodiment of the disclosure.
FIG. 17 is a view illustrating the antenna module of FIG. 15 disposed in a housing in an electronic device according to an embodiment of the disclosure.
FIG. 18 is a view illustrating a cross-section of a portion of an electronic device according to an embodiment of the disclosure taken along line A-A' of FIG. 17.
FIG. 19 is a first perspective view illustrating a keypad assembly of an electronic device according to an embodiment of the disclosure.
FIG. 20 is a second perspective view illustrating a keypad assembly of an electronic device according to an embodiment of the disclosure.
FIG. 21 is a view illustrating the keypad assembly of FIG. 19 or FIG. 20 disposed in a housing in an electronic device according to an embodiment of the disclosure.
FIG. 22 is a view illustrating a cross-section of a portion of an electronic device according to an embodiment of the disclosure taken along line B-B' of FIG. 21.
FIG. 23 is a view illustrating a cross-section of a portion of an electronic device according to an embodiment of the disclosure taken along line C-C' of FIG. 21.
FIG. 24 is a view illustrating flexible printed circuit board(s) disposed in an electronic device according to an embodiment of the disclosure.
FIG. 25 is a view illustrating a cross-section of a portion of an electronic device according to an embodiment of the disclosure taken along line D-D' of FIG. 24.
FIG. 26 is a first view illustrating a cover plate disposed in an electronic device according to an embodiment of the disclosure.
FIG. 27 is a second view illustrating a cover plate disposed in an electronic device according to an embodiment of the disclosure.

Throughout the drawings, like reference numerals may be assigned to like parts, components, and/or structures.

### [Mode for Carrying out the Invention]

Not only connection through a commercial communication network, but also communication protocols such as Bluetooth or Wi-Fi may provide an environment capable of directly connecting wireless communication between different electronic devices. For example, an electronic device may perform wireless communication of different protocols by including a plurality of antennas. However, in an electronic device that has become miniaturized or lightweight while performance has been further enhanced, it may be difficult to secure space for arranging a plurality of antennas. While securing space may be easy in a foldable or rollable electronic device, variations in wireless communication performance may occur in an electronic device where a plurality of structures (e.g., housings) are coupled to be relatively movable. For example, when a communication circuit and a radiator (or radiating body) of an antenna are disposed far apart, the shape of line (e.g., a coaxial cable or flexible printed circuit board) connecting the communication circuit and the radiator may change according to the relative positions of the structures. In signal transmission between the communication circuit and the radiator, changes in the shape of the line may cause a variation in signal transmission efficiency or may cause distortion of transmission signals.

An embodiment of the disclosure is to at least solve the above-mentioned problems and/or disadvantages and to at least provide the advantages described below, and may provide an electronic device including an antenna module that may be easily disposed in a narrow space.

An embodiment of the disclosure may provide an electronic device including an antenna module that implements a stable wireless communication environment while being disposed in a narrow space.

An embodiment of the disclosure may provide an electronic device including an antenna module that may suppress variations in wireless communication performance according to operating environment by suppressing or substantially preventing shape changes of line according to the relative positions of structures (e.g., housings).

The technical tasks to be achieved in the disclosure are not limited to the technical tasks mentioned above, and other unmentioned technical tasks can be clearly understood by one of ordinary skill in the art from the following description.

The following description taken in conjunction with the accompanying drawings may provide an understanding of various exemplary implementations of the disclosure, including claims and their equivalents. The exemplary embodiments disclosed in the following description include various specific details to aid understanding, but should be regarded as only one of the various exemplary embodiments. Accordingly, it will be understood by those skilled in the art that various changes and modifications may be made to the various implementations described in the disclosure without departing from the scope and spirit of the disclosure. Further, descriptions of well-known functions and configurations may be omitted for clarity and brevity.

The terms and words used in the following description and claims are not limited to the bibliographical meaning, but may be used to clearly and consistently describe an embodiment of the disclosure. Therefore, it will be apparent to those skilled in the art that the following description of various implementations of the disclosure is provided only for the purpose of description, not for the purpose of limiting the scope of the claims and their equivalents.

The singular forms "a," "an," and "the" are intended to include the plural forms as well, unless the context clearly indicates otherwise. Thus, as an example, "a component surface" may be interpreted as including one or more of the surfaces of a component.

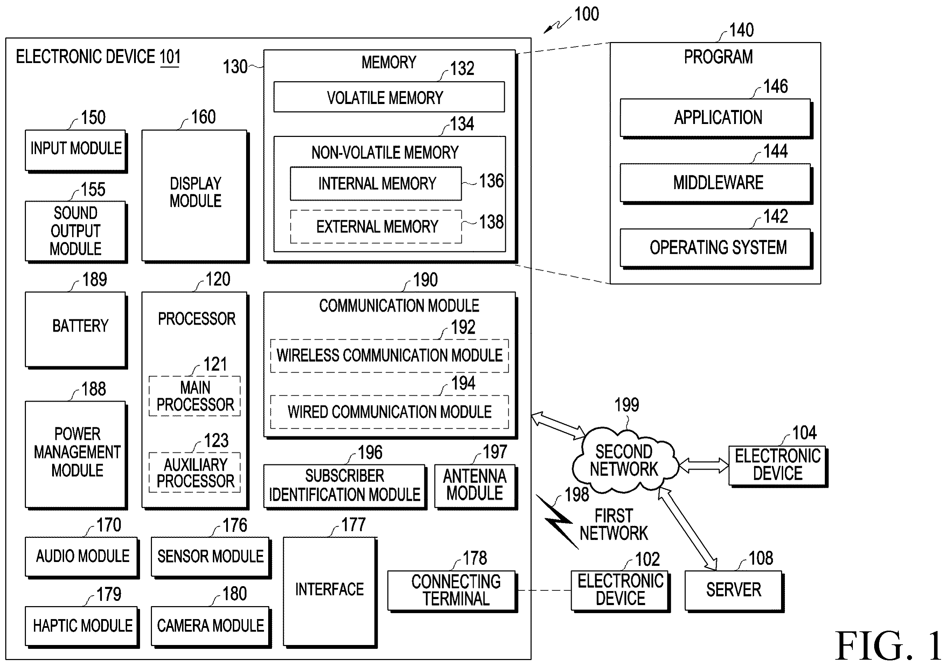

FIG. 1 is a block diagram illustrating an electronic device 101 in a network environment 100 according to an embodiment of the disclosure. Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., the program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., the electronic device 102) directly (e.g., wiredly) or wirelessly coupled with the electronic device 101.

The sensor module 176 may detect an operation state (e.g., power or temperature) of the electronic device 101 or an external environmental state (e.g., the user's state), and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module may include an antenna including a radiator formed of a conductor or conductive pattern formed on a substrate (e.g., a printed circuit board (PCB)). According to an embodiment, the antenna module 197 may include a plurality of antennas (e.g., an array antenna). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other components (e.g., radio frequency integrated circuit (RFIC)) than the radiator may be further formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to embodiment(s) of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

An embodiment of the disclosure and terms used therein are not intended to limit the technical features described in the disclosure to specific embodiments, and should be understood to include various modifications, equivalents, or substitutes of the embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "functionally" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be an integrally configured component, or a minimum unit or part thereof, adapted to perform one or more functions. For example, according to an embodiment, the module may be implemented in a form of an application-specific integrated circuit (ASIC).

Embodiments as set forth herein may be implemented as software (e.g., the program) including one or more instructions that are stored in a storage medium (e.g., internal memory or external memory) that is readable by a machine (e.g., the electronic device). For example, a processor (e.g., the processor) of the machine (e.g., the electronic device) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiment(s) of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities. Some of the plurality of entities may be separately disposed in different components. According to an embodiment, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

In the following detailed description, a length direction, a width direction, and/or a thickness direction of the electronic device may be mentioned and may be defined as a 'Y-axis direction,' 'X-axis direction', and/or 'Z-axis direction,' respectively. In an embodiment, with respect to the direction in which the component is oriented, 'negative/positive (-/+)' may be mentioned together with the Cartesian coordinate system exemplified in the drawings. For example, the front surface of the electronic device and/or housing may be defined as a 'surface facing in the +Z direction,' and the rear surface may be defined as a 'surface facing in the -Z direction'. In an embodiment, the side surface of the electronic device and/or housing may include an area facing in the +X direction, an area facing in the +Y direction, an area facing in the -X direction, and/or an area facing in the -Y direction. In an embodiment, the 'X-axis direction' may mean including both the '-X direction' and the '+X direction'. It should be noted that the directions are so defined with respect to the Cartesian coordinate system shown in the drawings for the sake of brevity of description, and that the description of these directions or components does not limit an embodiment(s) of the disclosure. For example, the Cartesian coordinate system may be defined differently from the disclosure depending on the design specifications of the electronic device or the user's usage habits.

In the following embodiments, a plurality of housings may be rotatably coupled to be rotatable relative to each other between a first position in which they are folded to face each other and a second position in which they are unfolded side by side. The description referring to the Cartesian coordinate system in mentioning the embodiment(s) of the electronic device in the following embodiment(s) may be described generally based on the unfolded state. In the electronic device according to the following embodiments, the folding axis(es) may be understood as substantially parallel to the Y-axis direction. However, embodiment(s) of the disclosure are not limited thereto, and embodiment(s) of the disclosure may be understood as including electronic devices having a structure in which the folding axis(es) is parallel to the X-axis direction.

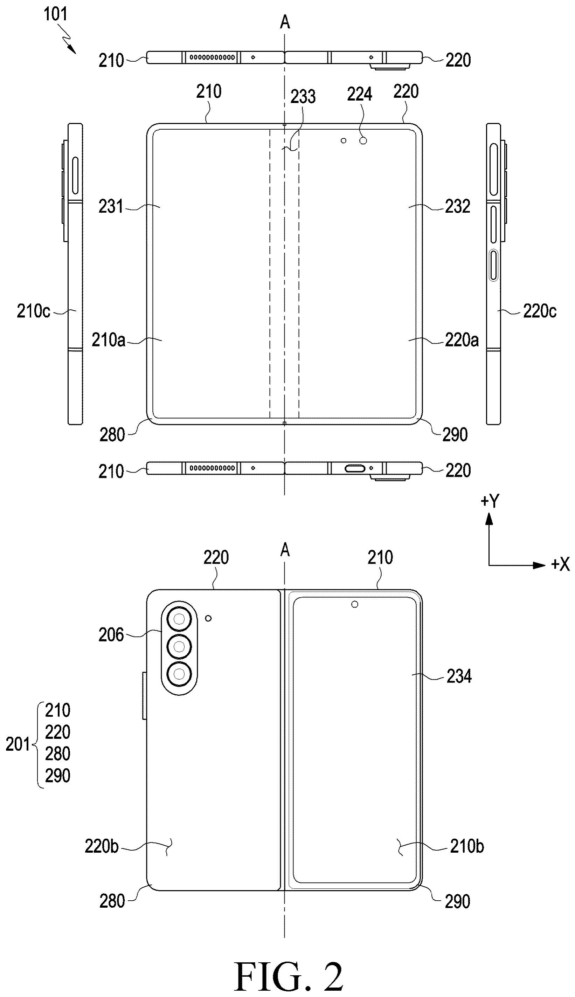

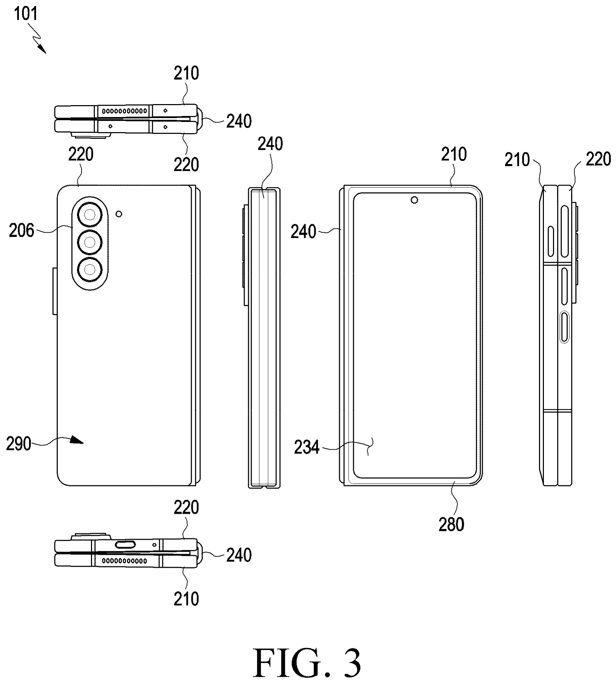

FIG. 2 is a view illustrating an unfolded state of an electronic device according to an embodiment of the disclosure. FIG. 3 is a view illustrating a folded state of an electronic device according to an embodiment of the disclosure.

Referring to FIGS. 2 and 3, an electronic device 101 may include a housing 201, a hinge cover 240 covering a foldable portion of the housing 201, and a display 230 disposed in a space formed by the housing 201. According to an embodiment, the surface where the screen output from the display 230 is exposed may be defined as a front surface (e.g., the first front surface 210a and the second front surface 220a) of the electronic device 101. A surface opposite to the front surface may be defined as a rear surface (e.g., the first rear surface 210b and the second rear surface 220b) of the electronic device 101. In an embodiment, a surface surrounding the space between the front surface and the rear surface may be defined as a side surface (e.g., the first side surface 210c and the second side surface 220c) of the electronic device 101. The side surface of the electronic device 101 may be a side surface of at least one of the first housing 210 or the second housing 220. The electronic device 101 of FIGS. 2 and 3 may be referred to as a foldable electronic device, a portable electronic device, or a portable foldable electronic device. According to an embodiment, the housing 201 may be referred to as a foldable housing. In an embodiment, the display 230 may be referred to as a flexible display.

According to an embodiment, the housing 201 may include a first housing 210, a second housing 220 rotatable with respect to the first housing 210, a first rear cover 280, and a second rear cover 290. The housing 201 of the electronic device 101 is not limited to the shape and coupling shown in FIGS. 2 and 3 but may rather be implemented in other shapes or via a combination and/or coupling of other components. For example, in an embodiment, the first housing 210 and the first rear cover 280 may be integrally formed with each other, and the second housing 220 and the second rear cover 290 may be integrally formed with each other.

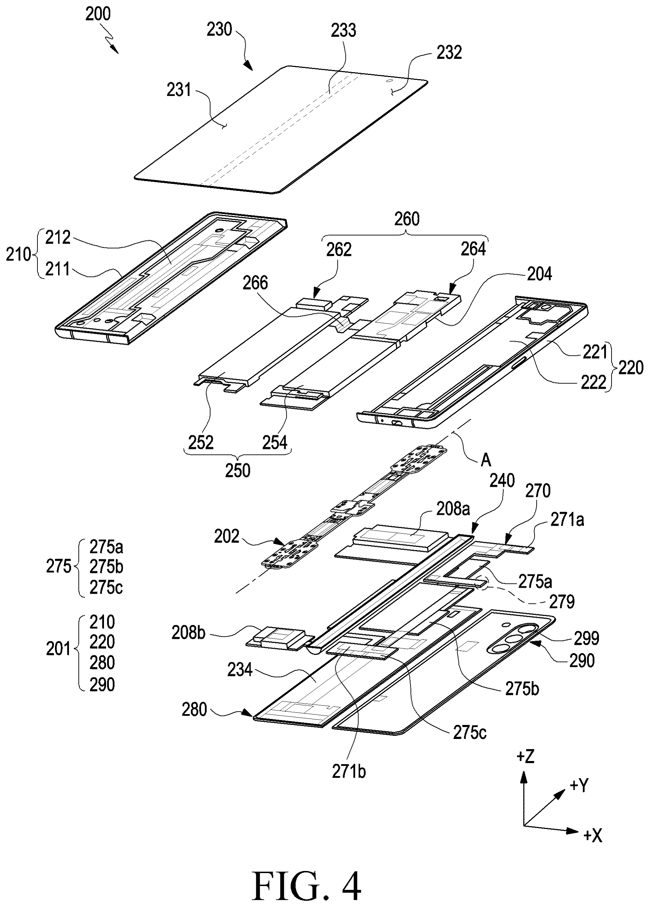

According to an embodiment, the first housing 210 may be connected to a hinge structure (e.g., the hinge assembly 202 of FIG. 4) and may include a first front surface 210a facing in a first direction and a first rear surface 210b facing in a second direction opposite to the first direction. The second housing 220 may be connected to the hinge assembly 202 and may include a second front surface 220a facing in a third direction and a second rear surface 220b facing in a fourth direction opposite to the third direction, and may rotate from the first housing 210 about the hinge assembly 202. Accordingly, the electronic device 101 may be changed to a folded state or an unfolded state. The folding or unfolding operation of the electronic device 101 may be understood as the rotation of the first housing 210 about the hinge structure or the rotation of the second housing 220 about the hinge structure. In the folded state of the electronic device 101, the first front surface 210a may face the second front surface 220a and, in the unfolded state, the third direction may be identical to the first direction. Hereinafter, unless otherwise mentioned, directions are described based on the unfolded state of the electronic device 101.

According to an embodiment, the first housing 210 and the second housing 220 are disposed on both sides of the folding axis A and are overall symmetrical in shape with respect to the folding axis A. As set forth below, the first housing 210 and the second housing 220 may have different angles or distances formed therebetween depending on whether the electronic device 101 is in the unfolded, folded, or intermediate state. According to an embodiment, the second housing 220 further includes the sensor area 224 where sensors (e.g., a front camera) are disposed but, in other areas, the second housing 220 may be symmetrical in shape with the first housing 210.

According to an embodiment, the folding axis A may be a plurality of (e.g., two) parallel folding axes. In the disclosure, the folding axis A is provided along the length direction (Y-axis direction) of the electronic device 101, but the direction of the folding axis A is not limited thereto. For example (not shown), an embodiment in which the electronic device 101 includes the folding axis extending along the width direction (e.g., X-axis direction) may be implemented.

According to an embodiment, the electronic device 101 may include a structure to which a digital pen (not shown) may be attached. For example, the electronic device 101 may include a magnetic substance configured to attach the digital pen to a side surface of the first housing 210 or a side surface of the second housing 220. According to an embodiment, the electronic device 101 may include a structure into which a digital pen may be inserted. For example, a hole (not shown) into which the digital pen may be inserted may be formed in a side surface of the first housing 210 or a side surface of the second housing 220 of the electronic device 101.

According to an embodiment, at least a portion of the first housing 210 and the second housing 220 may be formed of a metal or non-metallic material having a rigidity of a size selected to support the display 230. At least a portion formed of metal may provide a ground plane of the electronic device 101 and may be electrically connected with a ground line formed on a printed circuit board (e.g., the circuit board 260 of FIG. 4).

According to an embodiment, the sensor area 224 may be formed adjacent to an edge or corner of the second housing 220 to have a predetermined area. However, the placement, shape, or size of the sensor area 224 is not limited to those illustrated. For example, in another embodiment, the sensor area 224 may be provided in a different corner of the second housing 220 or in any area between the top corner and the bottom corner or in the first housing 210. In an embodiment, components for performing various functions, embedded in the electronic device 101, may be exposed through the sensor area 224 or one or more openings in the sensor area 224 to the front surface of the electronic device 101. In an embodiment, the components may include various kinds of sensors. The sensor(s) may include, e.g., at least one of a front camera, a receiver, or a proximity sensor.

According to an embodiment, the first rear cover 280 may be disposed on one side of the folding axis A on the rear surface of the electronic device 101 and have, e.g., a substantially rectangular periphery which may be surrounded by another structure of the first housing 210. Similarly, the second rear cover 290 may be disposed on the opposite side of the folding axis A on the rear surface of the electronic device 101 and its periphery may be surrounded by another structure of the second housing 220.

According to an embodiment, the first rear cover 280 and/or the second rear cover 290 may be substantially symmetrical in shape with respect to the folding axis (axis A). However, the first rear cover 280 and the second rear cover 290 are not necessarily symmetrical in shape. In an embodiment, the electronic device 101 may include the first rear cover 280 and the second rear cover 290 in different shapes, not symmetrical.

According to an embodiment, the first rear cover 280, the second rear cover 290, the first housing 210, and the second housing 220 may provide a space where various components (e.g., a printed circuit board or battery) of the electronic device 101 may be disposed. According to an embodiment, one or more components may be disposed or visually exposed on the rear surface of the electronic device 101. For example, at least a portion of a sub display 234 may be visually exposed through at least a portion of the first rear cover 280. In another embodiment, one or more components or sensors may be visually exposed through at least a portion of the second rear cover 290. According to various embodiments, the sensor may include a proximity sensor and/or a camera module 206 (e.g., a rear camera).

According to an embodiment, a front camera exposed to the front surface of the electronic device 101 through one or more openings provided in the sensor area 224 or the camera module 206 exposed through at least a portion of the second rear cover 290 may include one or more lenses, an image sensor, and/or an image signal processor. In an embodiment, two or more lenses (an infrared (IR) camera, a wide-angle lens, and a telephoto lens) and image sensors may be disposed on one surface of the electronic device 101.

According to an embodiment, the hinge cover 240 may be disposed between the first housing 210 and the second housing 220 to hide the internal components (e.g., the hinge assembly 202 of FIG. 4). According to an embodiment, the hinge cover 240 may be hidden by a portion of the first housing 210 and second housing 220 or be exposed to the outside depending on the state (e.g., the unfolded state (e.g., flat state) or folded state) of the electronic device 101.

According to an embodiment, as shown in FIG. 2, in the unfolded state of the electronic device 101, the hinge cover 240 may be hidden, and thus not exposed, by the first housing 210 and the second housing 220. As another example, as shown in FIG. 3, in the folded state (e.g., a fully folded state) of the electronic device 101, the hinge cover 240 may be exposed to the outside between the first housing 210 and the second housing 220. As another example, in an intermediate state in which the first housing 210 and the second housing 220 are folded with a certain angle, the hinge cover 240 may be partially exposed to the outside between the first housing 210 and the second housing 220. However, in this case, the exposed area may be smaller than that in the completely folded state. In an embodiment, the hinge cover 240 may include a curved surface.

According to an embodiment, the display 230 may be disposed in a space formed (or defined) by the housing 201. For example, the display 230 may be seated on a recess provided by the housing 201 and may form most of the front surface of the electronic device 101. Thus, the front surface of the electronic device 101 may include the display 230 and a partial area of the first housing 210 and a partial area of the second housing 220, which are adjacent to the display 230. The rear surface of the electronic device 101 may include a first rear cover 280, a partial area of the first housing 210 adjacent to the first rear cover 280, a second rear cover 290, and a partial area of the second housing 220 adjacent to the second rear cover 290.

According to an embodiment, the display 230 may include a plurality of display areas spaced apart from each other. For example, the display 230 may include a first display area 231 disposed on the first housing 210, a second display area 232 disposed on the second housing 220, and a folding area 233. According to an embodiment, the first display area 231 and the second display area 232 may rotate about the folding axis A.

According to an embodiment, the display 230 may mean a display at least a portion of which may be transformed into a flat or curved surface. For example, the display 230 may be a foldable or flexible display. According to an embodiment, the display 230 may include a folding area 233, a first display area 231 disposed on one side of the folding area 233 (e.g., the left side of the folding area 233 of FIG. 2), and a second display area 232 disposed on the opposite side of the folding area 233 (e.g., the right side of the folding area 233 of FIG. 2). However, the segmentation of the display 230 is merely an example, and the display 230 may be divided into a plurality of (e.g., four or more, or two) areas depending on the structure or function of the display 230. For example, in the embodiment illustrated in FIG. 2, the display 230 may be divided into the areas by the folding area 233 or folding axis A extending in parallel with the Y axis but, in another embodiment, the display 230 may be divided into the areas with respect to another folding area (e.g., a folding area parallel with the X axis) or another folding axis (e.g., a folding axis parallel with the X axis). According to an embodiment, the display 230 may be coupled with or disposed adjacent to a touch detection circuit, a pressure sensor capable of measuring the strength (pressure) of touches, and/or a digitizer (not shown) for detecting a magnetic field-type stylus pen.

According to an embodiment, the first display area 231 and the second display area 232 may be overall symmetrical in shape with respect to the folding area 233. According to an embodiment (not shown), unlike the first display area 231, the second display area 232 may include a notch cut depending on the presence of the sensor area 224, but in the remaining areas, it may be substantially symmetrical in shape to the first display area 231. For example, the first display area 231 and the second display area 232 may include symmetrical portions and asymmetrical portions.

Described below are the operation of the first housing 210 and the second housing 220 and each area of the display 230 depending on the state (e.g., the unfolded state (or flat state) and folded state) of the electronic device 101.

According to an embodiment, when the electronic device 101 is in the unfolded state (flat state) (e.g., FIG. 2), the first housing 210 and the second housing 220 may be disposed to face in the same direction while being angled substantially at 180 degrees therebetween. The surface of the first display area 231 and the surface of the second display area 232 of the display 230 may be angled at 180 degrees therebetween while facing in the same direction (e.g., forward of the front surface of the electronic device). The folding area 233 may form the same plane with the first display area 231 and the second display area 232.

According to an embodiment, when the electronic device 101 is in the folded state (e.g., FIG. 3), the first housing 210 and the second housing 220 may be disposed to face each other. The surface of the first display area 231 and the surface of the second display area 232 of the display 230 may be angled at a small angle (e.g., an angle between about 0 degrees and about 10 degrees) therefrom while facing each other. In the folded state of the electronic device 101, at least a portion of the folding area 233 may be formed as a curved surface having a predetermined curvature.

According to an embodiment, when the electronic device 101 is in the intermediate state (not shown), the first housing 210 and the second housing 220 may be disposed at a certain angle therebetween. The surface of the first display area 231 of the display 230 and the surface of the second display area 232 may form an angle which is larger than the angle in the folded state and smaller than the angle in the unfolded state. The folding area 233 may at least partially have a curved surface with a predetermined curvature and, in this case, the curvature may be smaller than that when it is in the folded state.

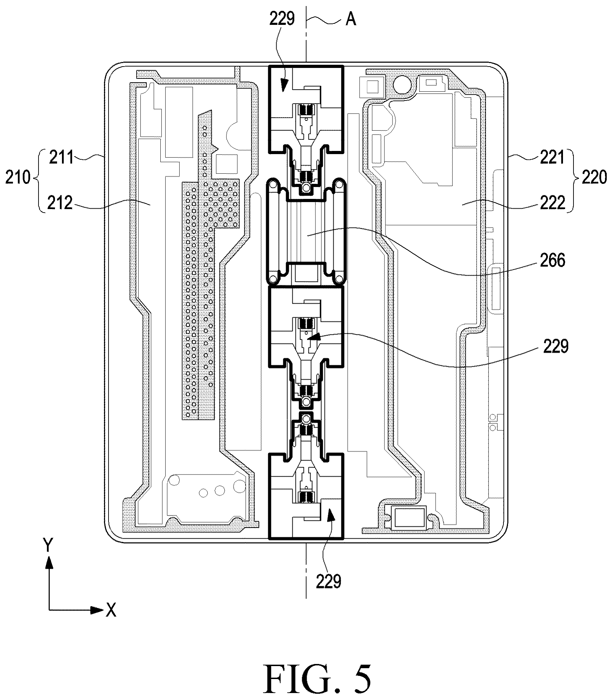

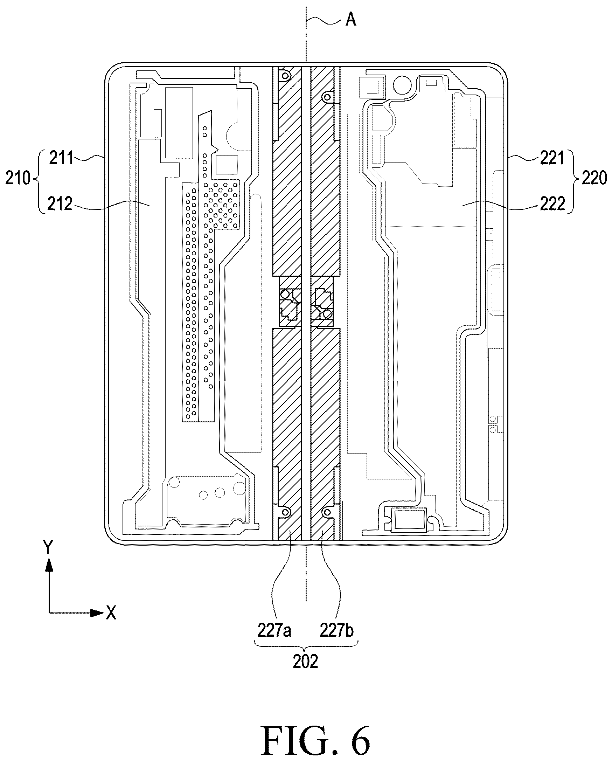

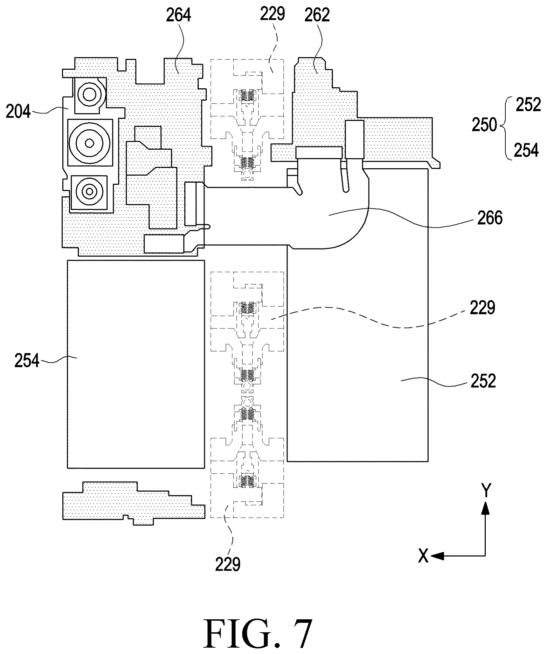

FIG. 4 is an exploded perspective view illustrating an electronic device according to an embodiment of the disclosure. FIG. 5 is a view illustrating housings coupled together in an electronic device according to an embodiment of the disclosure. FIG. 6 is a view illustrating hinge plates disposed in an electronic device according to an embodiment of the disclosure. FIG. 7 is a view illustrating an arrangement of hinge module(s) and electronic components inside an electronic device according to an embodiment of the disclosure.

Referring to FIGS. 4 to 7, an electronic device 200 (e.g., the electronic device 101 of FIGS. 1 to 3) may include a housing 201, a display 230, a hinge assembly 202, a battery 250, and a board unit 260. For example, the housing 201 may include a first housing 210, a second housing 220, a first rear cover 280, and a second rear cover 290. In an embodiment, the housing 201 may be understood as including a hinge cover 240. The configuration of the first housing 210, the second housing 220, the hinge cover 240, the first rear cover 280, and the second rear cover 290 of FIG. 4 may be identical in whole or part to the configuration of the first housing 210, the second housing 220, the hinge cover 240, the first rear cover 280, and the second rear cover 290 of FIG. 2 and/or FIG. 3.

According to an embodiment, the first housing 210 and the second housing 220 may be assembled together to be coupled to two opposite sides of the hinge assembly 202. For example, the hinge assembly 202 may be disposed in a hinge area between the first housing 210 and the second housing 220 to rotatably couple the first housing 210 and the second housing 220. Here, the 'hinge area' may refer to a space where the hinge assembly 202 is disposed, an area at least partially surrounded by the hinge cover 240, and/or a space between the hinge cover 240 and the folding area 233 of the display 230. In an embodiment, the hinge area may be understood as a space disposed substantially corresponding to the folding area 233.

According to an embodiment, as exemplified in FIGS. 5 to 7, the hinge assembly 202 may include at least one hinge module 229 and a plurality of hinge plates 227a and 227b. In the illustrated embodiment, three hinge modules 229 are sequentially disposed along the direction of a folding axis A, and a flexible printed circuit board 266 may be disposed across the folding axis A through an area between two hinge modules 229. As will be described below, by disposing (or implementing) a plurality of antennas or radiators around the camera assembly 204 (e.g., the camera module 206 of FIG. 2 or FIG. 3), design flexibility of the flexible printed circuit board 266 may be increased. For example, as more antennas are implemented in one of the plurality of housings 210 and 220 and disposed in the same housing as a communication circuit (e.g., the communication module 190 of FIG. 1), a transmission line between the communication circuit and the antenna in line crossing the folding axis A may be simplified.

Although not illustrated, the hinge module 229 may include a hinge portion providing the folding axis(es) (A) and an interlocking portion for interlocking relative movement of the housings 210 and 220. For example, the housing(s) 210 and 220 may be coupled to the hinge module 229 to rotate relative to the hinge module 229 or the hinge cover 240. The interlocking portion may include, e.g., a first gear that rotates on the hinge cover 240 as the first housing 210 rotates, and a second gear that rotates on the hinge cover 240 as the second housing 220 rotates. In an embodiment, when the first gear and the second gear are engaged, the first housing 210 and the second housing 220 may be configured to rotate in reverse directions relative to each other. For example, when the first housing 210 rotates clockwise on the hinge cover 240, the hinge assembly 202 (e.g., the interlocking portion of the hinge module 229) may rotate the second housing 220 counterclockwise on the hinge cover 240. In an embodiment, by further disposing a plurality (e.g., one pair or two pairs) of gears between the first gear and the second gear, rotation of the first housing 210 and the second housing 220 may be interlocked. The number of gears included in the hinge module 229 (e.g., interlocking part) may be appropriately selected according to design specifications of the electronic device such as size or shape of the arrangement space.

According to an embodiment, the hinge plate(s) 227a and 227b may connect either one of the housings 210 and 220 to the hinge module 229. For example, the hinge plate indicated by '227a' among the hinge plates 227a and 227b may mechanically connect or fix the first housing 210 to the hinge module(s) 229, and the hinge plate indicated by '227b' may mechanically connect or fix the second housing 220 to the hinge module(s) 229. In the unfolded state of FIG. 2, the hinge plates 227a and 227b may be aligned to form a continuous plane to support a portion of the display 230 (e.g., the folding area 233 of FIG. 2 or FIG. 4). In the folded state of FIG. 3, the hinge plates 227a and 227b may be disposed to be inclined relative to each other and may implement a space receiving the folding area 233 deformed into a curved shape. In an embodiment, when the hinge plates 227a and 227b provide a space receiving the folding area 233 while being inclined relative to each other, the folding area 233 may maintain a curved shape within a designated curvature in the folded state. For example, in the folded state of FIG. 3, by the folding area 233 having a radius of curvature of a designated size, it may be protected from damage due to excessive folding, and the surfaces of the first display area 231 and the second display area 232 may be disposed at substantially 0 degrees angle.

According to an embodiment, the first housing 210 may include a first supporting area 212 (e.g., a first supporting member) that may support the components (e.g., the first circuit board 262 and/or the first battery 252) of the electronic device 200 and a first sidewall 211 surrounding at least a portion of the first supporting area 212. The first sidewall 211 may include a first side surface (e.g., the first side surface 210c of FIG. 2) of the electronic device 200. According to an embodiment, the second housing 220 may include a second supporting area 222 that may support the components (e.g., the second circuit board 264 and/or the second battery 254) of the electronic device 200 and a second sidewall 221 surrounding at least a portion of the second supporting area 222. The second sidewall 221 may include a second side surface (e.g., the second side surface 220c of FIG. 2) of the electronic device 200.

According to an embodiment, the first side wall 211 or the second side wall 221 may be understood as a frame shape that at least partially surrounds a space between the front surface and the rear surface of the electronic device 200(e.g., the first housing 210 or the second housing 220). In an embodiment, the support areas 212 and 222 may be structures extending from either one of the side walls 211 and 221. For example, although the support areas 212 and 222 and the side walls 211 and 221 are described separately for convenience of description, the embodiment(s) of the disclosure are not limited thereto, and the support areas 212 or 222 and the side walls 211 or 221 may be implemented as a single body. In an embodiment, the support areas 212 or 222 and the side walls 211 or 221 may be implemented by combining an insulating material and a conductive material, and in this case, the housings 210 and 220 may be integrally implemented with the support areas 212 or 222 and the side walls 211 or 221 through an insert injection process and/or computer numerical control machining process. As will be seen through the embodiments described below, when including a conductive material, portions of the support areas 212 and 222 and the side walls 211 and 221 may function as antenna(s) or radiator(s).

According to an embodiment, as mentioned above, at least a portion of one of the housings 210 and 220 in the electronic device 200 may function as an antenna. In an embodiment, the portion of the electronic device 200 that functions as an antenna may implement a side surface of at least one of the housings 210 and 220. In an embodiment, the portion of the electronic device 200 that functions as an antenna may be disposed to be adjacent to a side surface of at least one of the housings 210 and 220 and/or to face in a direction crossing the Z-axis. For example, the portion of the electronic device 200 that functions as an antenna may be implemented by portions of the housings 210 and 220, or may be disposed adjacent to edges of the housings 210 and 220 while being manufactured in the form of a component separate from the housings 210 and 220. In an embodiment, "the portion of the electronic device 200 that functions as an antenna is implemented by portions of the housings 210 and 220" may be understood as including, e.g., an example in which the portion functioning as an antenna is disposed to form a side surface of at least one of the housings 210 and 220.

According to an embodiment, although not illustrated, the first housing 210 may include a first waterproofing member disposed in the first supporting area 212 and/or the second housing 220 may include a second waterproofing member disposed in the second supporting area 222. The first waterproofing member and/or the second waterproofing member may be disposed in the gaps between the display 230 and the supporting area(s) 212 and 222 to suppress influx of moisture or foreign bodies from the outside to the inside of the first housing 210 and/or the second housing 220.

According to an embodiment, the display 230 may include a first display area 231, a second display area 232, and/or a folding area 233. The configuration of the first display area 231, the second display area 232, and the folding area 233 of FIG. 3 may be identical in whole or part to the configuration of the first display area 231, the second display area 232, and the folding area 233 of FIG. 2.

According to an embodiment, the electronic device 200 may further include a sub display 234. In an embodiment, the sub display 234 may display a screen in a different direction from the display areas 231 and 232. For example, the sub display 234 may output screen in a direction opposite to the first display area 231. According to an embodiment, the sub display 234 may be disposed on the first rear cover 280. For example, the sub display 234 may be understood as a portion of the first rear cover 280, and in an embodiment, the sub display 234 may be disposed inside the first rear cover 280 and visually exposed to the outside through the first rear cover 280.

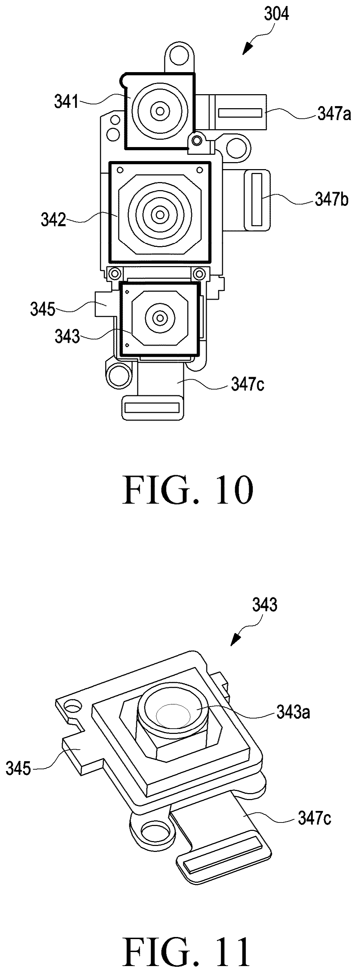

According to an embodiment, the electronic device 200 may include a camera assembly 204 (e.g., the camera module 206 of FIG. 2 or 3) in which a plurality of cameras are combined. Although not illustrated, it may further include a camera that photographs a subject through a portion of the display 230 (e.g., the first display area 231 or the second display area 232) or a camera that photographs a subject through a portion of the sub display 234. As will be described below, the camera assembly 204 may include a plurality of cameras with different angles of view. For example, a camera with an angle of view of about 100 degrees or more (e.g., the first camera 341 of FIG. 10), a camera with an angle of view of about 65 degrees to 85 degrees (e.g., the second camera 342 of FIG. 10), and/or a camera with an angle of view of about 15 degrees to 40 degrees (e.g., the third camera 343 of FIG. 10) may be included in the camera assembly 204. In an embodiment, an additional camera with an angle of view different from the above-mentioned range (e.g., about 40 degrees to 60 degrees) may be included in the camera assembly.

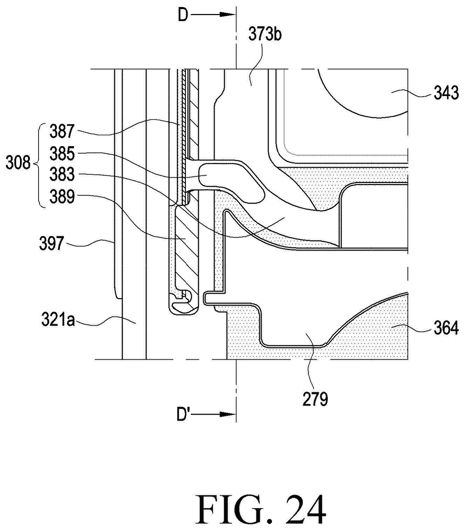

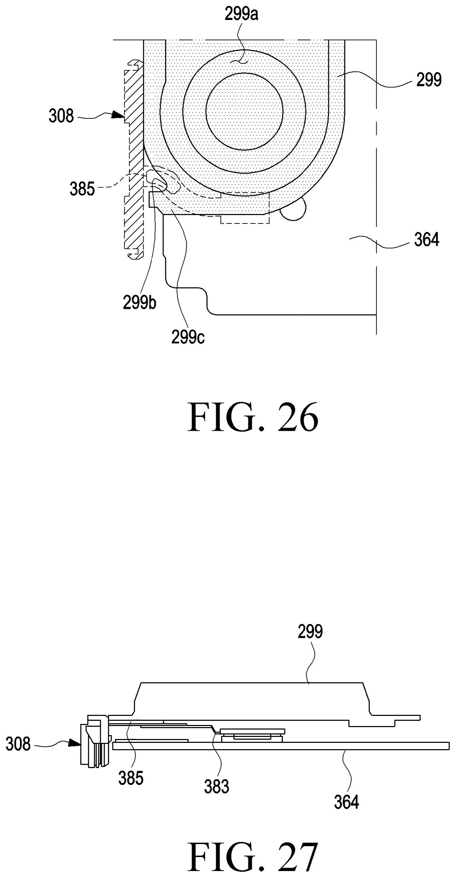

According to an embodiment, the electronic device 200 and/or the second rear cover 290 may include a cover plate 299 disposed corresponding to the camera assembly 204. The cover plate 299 may provide an optical path (e.g., a through hole) corresponding to the camera assembly 204, to be harmonized with the outer appearance of the electronic device 200. To provide an aesthetic appeal to the appearance of the electronic device 200 or to achieve a harmonious appearance, the cover plate 299 may include a metal material. For example, the cover plate 299 may be formed of a metal material, or may be finished (e.g., printed, deposited, coated or plated) with a metal material. In an embodiment, the cover plate 299 may be understood as a portion of the second rear cover 290, and a portion (e.g., edge) thereof may be disposed in the second rear cover 290, and another portion may be disposed while being exposed to the outside. As will be described below, when a cover plate 299 includes a metallic material, e.g., a material having conductivity, by including a notch portion in at least a portion of an area overlapping transmission line (the flexible printed circuit boards 373b and 383 of FIG. 24 or FIG. 26), formation of electromagnetic coupling may be suppressed.

According to an embodiment, the battery 250 may include a first battery 252 disposed in the first housing 210 and a second battery 254 disposed in the second housing 220. According to an embodiment, the first battery 252 may be connected with the first circuit board 262, and the second battery 254 may be connected to the second circuit board 264. According to an embodiment, the battery 250 may supply power to at least one component of the electronic device 200. According to an embodiment, the battery 250 may include, e.g., a non-rechargeable primary battery, a rechargeable secondary battery, or a fuel cell.

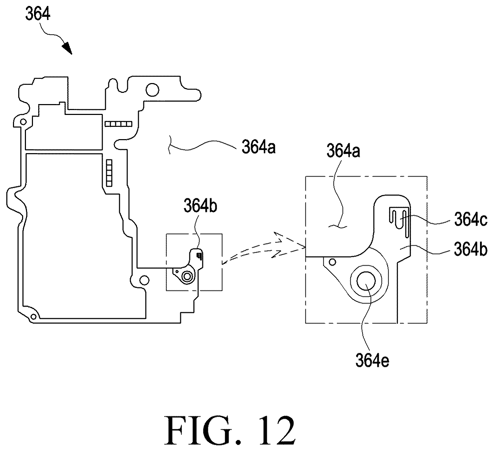

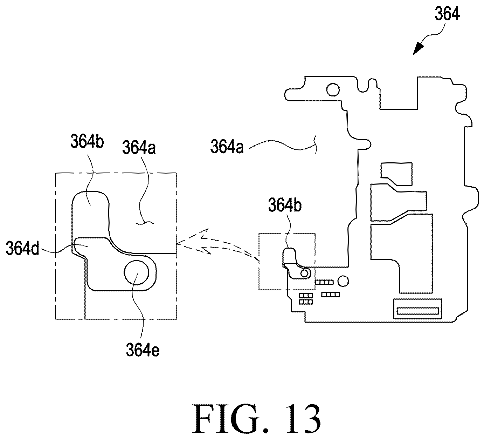

According to an embodiment, the board unit 260 may include a first circuit board 262 disposed in the first housing 210 and a second circuit board 264 disposed in the second housing 220. According to an embodiment, the first circuit board 262 and the second circuit board 264 may be electrically connected by at least one flexible printed circuit board 266. According to an embodiment, at least a portion of the flexible printed circuit board 266 may be disposed across the hinge area or hinge structure (e.g., the hinge assembly 202). According to an embodiment, the first circuit board 262 and the second circuit board 264 may be disposed in a space formed by the first housing 210, the second housing 220, the first rear cover 280, and the second rear cover 290. Components for implementing various functions of the electronic device 200 may be disposed on the first circuit board 262 and the second circuit board 264. As will be described below, either one of the first circuit board 262 and the second circuit board 264 may provide an opening area (e.g., the opening area 364a of FIG. 12 or FIG. 13) receiving the camera assembly 204.

According to an embodiment, the electronic device 200 may include speakers 208a and 208b. According to an embodiment, the speakers 208a and 208b may convert the electric signal into sound. According to an embodiment, the speakers 208 and 208b may be disposed in a space formed by the first housing 210, the second housing 220, the first rear cover 280, and the second rear cover 290. According to an embodiment, the speakers 208a and 208b may include an upper speaker 208a positioned in an upper portion (+Y direction) of the electronic device 200 and a lower speaker 208b positioned in a lower portion (-Y direction) of the electronic device 100. In the disclosure, the speakers 208a and 208b are illustrated as positioned in one housing (e.g., the first housing 210 of FIG. 4), but this is an optional structure. For example, the speakers 208a and 208b may be positioned in at least one of the first housing 210 or the second housing 220. The configuration of the speakers 208a and 208b of FIG. 4 may be identical in whole or part to the configuration of the sound output module 155 of FIG. 1.

According to an embodiment, the electronic device 200 may include a rear member 270 (or rear case). According to an embodiment, the rear member 270 may be disposed in the housing 201 (e.g., the second housing 220). According to an embodiment, the rear member 270 may accommodate at least one antenna 275. In an embodiment, the rear member 270 may function as a structure for disposing the antenna 275 and may function as a structure for supporting or protecting one of the circuit boards 262 and 264. For example, a portion of rear member 270 denoted by reference number '279' may support a portion of circuit boards 262 and 264.

According to an embodiment, the electronic device 200 may include an antenna 275. The antennas 275a and 275b may include, e.g., an ultra-wide band (UWB) antenna 275a, a near-field communication (NFC) antenna, a wireless charging antenna, and/or a magnetic secure transmission (MST) antenna 275b. The antenna 275 may perform short-range communication with, e.g., an external device or may wirelessly transmit or receive power necessary for charging.

According to an embodiment, an antenna structure may be formed by a portion of the housing 201 or a combination thereof. For example, an antenna 275 may include an additional antenna 275c that is at least partially exposed to the outside of the electronic device 200 and forms at least a portion of the outside of the electronic device 200. In an embodiment, the antenna 275c may be used for communication with an external electronic device (e.g., Wi-Fi). For example, the antenna 275c may be located at an upper portion 271a or a lower portion 271b of the rear member 270. Further, the electronic device 200 may further include an additional antenna disposed adjacent to electronic components such as a portion of the side walls 211 and 221 or the camera assembly 204, which will be examined through the embodiments described below.

In the following detailed description, a configuration in which a pair of housings (or referred to as a 'housing structure') are coupled to be rotatable by a hinge structure (or referred to as a 'hinge assembly 202') is described as an example. However, it should be noted that the electronic device according to various embodiments of the disclosure is not limited thereto. For example, the electronic device according to embodiment(s) of the disclosure may include three or more housings. In the embodiment disclosed below, a "pair of housings" may refer to two rotatably-coupled housings among three or more housings. In an embodiment, all configurations of the electronic device 101 of FIG. 1 may be included in either the first housing 210 or the second housing 220 described above, and in this case, either the first housing 210 or the second housing 220 itself may be understood as an embodiment of an electronic device. For example, it should be noted that the embodiment(s) of an electronic device according to the disclosure are not limited by the number of housing(s) or a coupling structure implemented between a plurality of housings.

In the embodiments described below, the same reference numbers may be given or omitted for overlapping components or components that may be easily understood through the preceding embodiments, and their detailed descriptions may be omitted. Although reference numbers are given in the drawings, even when not mentioned in the detailed description referring to the corresponding drawing, those skilled in the art are able to easily understand the corresponding configuration throughout the detailed description of the disclosure.

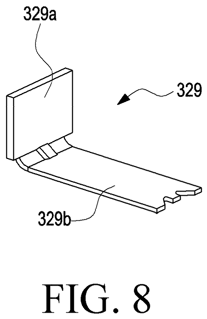

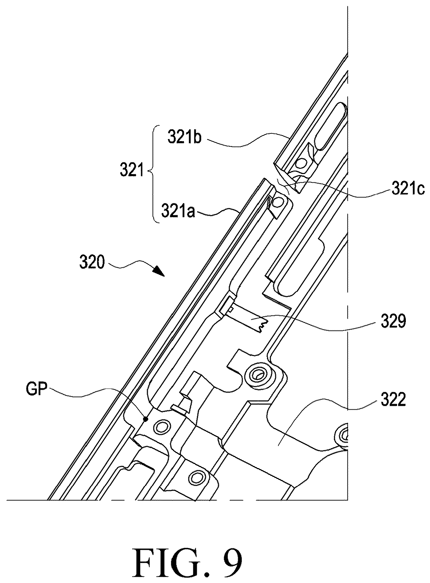

FIG. 8 is a perspective view illustrating a contact piece of an electronic device according to an embodiment of the disclosure. FIG. 9 is a perspective view illustrating a contact piece disposed in an electronic device according to an embodiment of the disclosure.

Referring further to FIGS. 8 and 9, the electronic device 200 may include a contact piece(s) 329. The contact piece 329 is, e.g., a plate or leaf spring bent in an alphabetical 'L' shape, and may be disposed on the first portion 321a of the side wall 321 (e.g., the second side wall 221 of FIG. 4). The first portion 321a of the side wall 321 forms, e.g., a portion of a frame shape and may at least partially include a conductive material. The contact piece 329 may include a fixing portion 329a disposed on an inner surface of the first portion 321a and a contact portion 329b bent at a designated angle relative to the fixing portion 329a. With the fixing portion 329a disposed on the inner surface of the first portion 321a, the contact portion 329b may be understood as extending from the inner surface of the first portion 321a toward the inside of the housing 320 (e.g., the second housing 220 of FIG. 4). For example, the fixing portion 329a may be fixed to the inner surface of the first portion 321a by welding or soldering, and/or by conductive adhesive or conductive tape. In the illustrated embodiment, the contact piece 329 may be manufactured by processing a metal plate, and notches or recesses may be created at portions of edges during the processing. However, the shape or structure of the contact piece 329 is not limited by what is illustrated in the drawings, and the edges of the contact piece 329 may be substantially straight.

According to an embodiment, the first portion 321a of the side wall 321 may be electrically connected to a communication circuit (e.g., the communication module 190 of FIG. 1) through the contact piece 329. For example, the electronic device 200, a processor (e.g., the processor 120 of FIG. 1), and/or a communication module (e.g., the communication module 190 of FIG. 1) may perform wireless communication using the first portion 321a. In an embodiment, the first portion 321a may function as a radiator performing wireless communication in at least one of an about 1.8 GHz frequency band, an about 2.4 GHz frequency band, and/or a 3.5 GHz frequency band. However, it should be noted that the embodiment(s) of the disclosure are not limited thereto, and the wireless communication frequency bands performed through the portions functioning as radiators are not limited to the above-mentioned or later-described frequency bands. In an embodiment, when the first portion 321a functions as a radiator, the contact piece 329 may be provided as a feeding point, and the portion indicated by 'GP' in FIG. 9 may be provided as a shorting point or grounding point. For example, the first portion 321a may be implemented as an inverted-F type antenna.

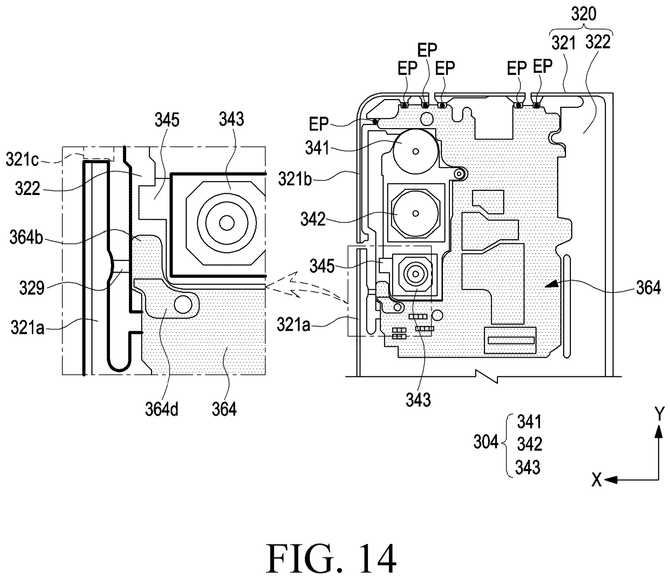

According to an embodiment, the side wall 321 may include a second portion 321b adjacent to the first portion 321a and segmented from the first portion 321a. In an embodiment, the second portion 321b (e.g., outer surface) may be disposed to form a continuous curved surface or continuous plane with the first portion 321a when viewed from outside the electronic device 200. In FIG. 9, although not illustrated in the drawings, the portion indicated by '321c' may substantially illustrate a segmented structure (e.g., the segmented structure 321c of FIG. 14, FIG. 16, and/or FIG. 17). For example, the first portion 321a and the second portion 321b may be electrically insulated from each other while mechanically connected or coupled by an insulating material provided as the segmented structure 321c. When including a conductive material (e.g., metal) and the segmented structure 321a, the housing 320 (e.g., the side wall 321 and/or the support area 322) may be manufactured through an insert injection process. For example, the segmented structure 321c may be molded with a previously manufactured conductive portion disposed in a mold, and after molding, a housing 321 of design shape may be manufactured through additional processes such as computer numerical control machining as needed.

FIG. 10 is a view illustrating a camera assembly of an electronic device according to an embodiment of the disclosure. FIG. 11 is a perspective view illustrating a third camera among the camera assembly of FIG. 10 in an electronic device according to an embodiment of the disclosure.

Referring to FIGS. 10 and 11, a camera assembly 304 (e.g., the camera assembly 204 of FIG. 4 or FIG. 7) may include a plurality of cameras 341, 342, and 343. For example, the camera assembly 304 may include a first camera 341 providing ultra-wide-angle performance, a second camera 342 providing wide-angle performance, and/or a third camera 343 providing telephoto performance. Here, it should be noted that optical performances (e.g., angle of view or focal length) such as 'ultra-wide-angle', 'wide-angle', and/or 'telephoto' are not limited to being defined by the specifications of the cameras 341, 342, and 343. For example, the optical performance of the cameras 341, 342, and 343 mentioned in the embodiment(s) of the disclosure may be defined by relative comparison of the angles of view or focal lengths of the cameras 341, 342, and 343 included in the camera assembly 304.

According to an embodiment, the cameras 341, 342, and 343 may be disposed along a length direction of the electronic device 200 or the housing 320 (e.g., Y-axis direction of FIG. 4). In an embodiment, the cameras 341, 342, and 343 may be disposed along a width direction of the electronic device 200 (e.g., X-axis direction of FIG. 4) or disposed along a closed-loop trajectory. For example, the number and arrangement of the cameras 341, 342, and 343 do not limit the embodiment(s) of the disclosure and may be varied according to specifications of the electronic device 200. In an embodiment, the cameras 341, 342, and 343 may be electrically connected to a circuit board (e.g., the second circuit board 264 of FIG. 4 or the circuit board 364 of FIG. 12) by including line board(s) 347a, 347b, and 347c.

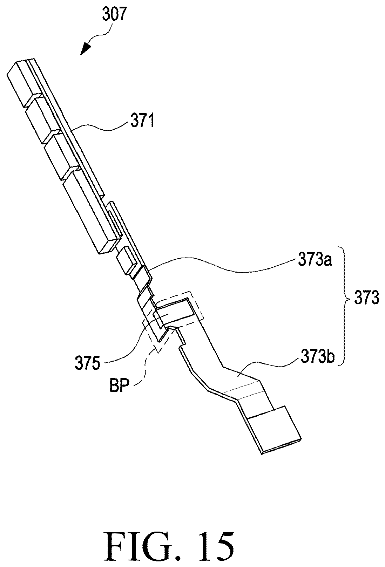

According to an embodiment, the electronic device 200 and/or the camera assembly 304 may further include a support protrusion 345. In an embodiment, when another electronic component (e.g., the antenna module 307 of FIG. 15) is disposed adjacent to the camera assembly 304, the support protrusion 345 may provide a structure supporting the other electronic component or an alignment structure for lines (e.g., the first flexible printed circuit board 373 of FIG. 15) of the other electronic component. In the illustrated embodiment, the support protrusion 345 may be understood as protruding from one side surface of the third camera 343. However, the embodiment(s) of the disclosure are not limited thereto, and an additional support protrusion may be provided on the first camera 341 or the second camera 342, and/or when a support protrusion is provided on the first camera 341 or the second camera 342, the support protrusion 345 of the third camera 343 may be omitted. For example, the support protrusion 345 may be variously implemented according to the position of electronic components disposed adjacent to the camera assembly 304 or line paths.

FIG. 12 is a first view illustrating a circuit board of an electronic device according to an embodiment of the disclosure. FIG. 13 is a second view illustrating a circuit board of an electronic device according to an embodiment of the disclosure.

Referring to FIGS. 12 and 13, a circuit board 364 (e.g., the second circuit board 264 of FIG. 4) may provide an opening area 364a at one edge. Although reference numbers are not given, electric/electronic component(s) such as integrated circuit chips, and/or various connectors may be disposed on at least one surface of the circuit board 364. The connector(s) may provide a connection structure with electronic components such as the camera assembly 304. The opening area 364a may provide, e.g., a space receiving at least a portion of the camera assembly 304. In an embodiment, when the circuit board 364 is aligned to overlap the camera assembly 304 in a thickness direction (e.g., Z-axis direction of FIG. 4) between the front surface (e.g., the second front surface 220a of FIG. 2) and the rear surface (e.g., the second rear surface 220b of FIG. 2) of the housing 320, the thickness of the electronic device 200 may increase. The opening area 364a provides a space or area where the camera assembly 304 may be disposed, thus suppressing an increase in thickness of the electronic device 200 in the arrangement of the camera assembly 304 and the circuit board 364. For example, the circuit board 364 may be disposed not to overlap the camera assembly 304 in the thickness direction between the front surface and the rear surface of the housing 320.

According to an embodiment, the circuit board 364 may include an extension 364b that defines a portion of the opening area 364a, or that at least partially surrounds the opening area 364a. As will be described below, the extension 364b may be disposed, e.g., between the first portion 321a and the camera assembly 304 within the housing 320. In an embodiment, the contact piece 329 (e.g., the contact portion 329b) may be disposed to at least partially face the extension 364b. For example, the extension may be disposed between the side wall (e.g., the first portion) and the camera assembly in the width direction of the electronic device 200 (e.g., X-axis direction of FIG. 4) and may be disposed to face the contact piece in the thickness direction of the electronic device 200 (e.g., Z-axis direction of FIG. 4). In an embodiment, the contact piece 329 may be understood as being disposed between the front surface of the housing 320 and the extension 364b in the thickness direction of the electronic device 200. In an embodiment, the extension 364b may be utilized as a portion that substantially electrically connects the contact piece 329 and/or the side wall 321 (e.g., the first portion 321a) to the circuit board 364.

According to an embodiment, when the first portion 321a and/or the contact piece 329 are electrically connected to the circuit board 364, the electronic device 200 and/or the circuit board 364 may further include a contact terminal 364c of a leaf spring structure disposed on one surface of the circuit board 364 (e.g., the extension 364b). In an embodiment, when the first portion 32a functions as a radiator, the contact terminal 364c directly contacts the contact piece 329 (e.g., the contact portion 329b), whereby the first portion 321a and/or the contact piece 329b may be electrically connected to the circuit board 364 through the contact terminal 364c. For example, the first portion 321a functioning as a radiator may receive a power supply signal via the contact piece 329 and/or the contact terminal 364c. In an embodiment, the contact portion 329b may be manufactured with a curved shape to directly contact the circuit board 364 (e.g., the extension 364b), and in this case, the contact terminal 364c may be replaced with a flat pad rather than a leaf spring structure.

According to an embodiment, to stably maintain the contact state between the contact piece 329 and the contact terminal 364c, the contact piece 329 or the contact terminal 364c may have a leaf spring structure. For example, when the circuit board 364 is disposed on the housing 320, as the contact piece 329 and the contact terminal 364c contact each other, they may be partially deformed or partially moved while accumulating elastic force. In an embodiment, the extension 364b may have a width small enough to be disposed in a narrow gap between the first portion 321a and the camera assembly 304. In this case, the elastic force accumulated by the contact piece 329 and the contact terminal 364c may deform or damage the extension. For example, when the extension 364b is deformed, it may be difficult to stably maintain the connection between the contact piece 329 and the contact terminal 364c, and the durability of the extension 364b may deteriorate.

According to an embodiment, the electronic device 200 and/or the circuit board 364 may further include a support plate 364d, thereby suppressing deformation of the extension 364c and stably maintaining the connection state between the contact piece 329 and the contact terminal 364c. In an embodiment, the support plate 364d may be formed of a metal material such as stainless steel and may be disposed on the other surface of the circuit board 364. In an embodiment, the support plate 364d may be understood as being disposed at least partially on the other surface of the extension 364b. For example, even when elastic force is applied to the extension 364b by the contact piece 329 and the contact terminal 364c, the support plate 364d supports the extension 364b, thereby suppressing deformation or damage of the extension 364b.

According to an embodiment, the electronic device 200 and/or the circuit board 364 may further include a fastening hole 364e penetrating the circuit board 364 and/or the support plate 364d in an area adjacent to the extension 364b. For example, when fixing the circuit board 364 within the housing 320 (e.g., the support area 322), a fastening member such as a screw may fix the circuit board 364 and the support plate 364d to the support area 322 through the fastening hole 364e. The fastening force provided by the fastening member may further suppress deformation of the extension 364b and/or the support plate 364d by elastic force.

FIG. 14 is a view illustrating the camera assembly of FIG. 11 and the circuit board of FIG. 13 disposed in a housing in an electronic device according to an embodiment of the disclosure.

Referring further to FIG. 14, within the space at least partially surrounded by the side wall 321, the camera assembly 304 may be disposed adjacent to a portion of the side wall 321. For example, the camera assembly 304 may be disposed adjacent to the first portion 321a and/or the second portion 321b of the side wall 321 on the support area 322 of the housing 320. The support protrusion 345 of the camera assembly 304 may be disposed, e.g., in the form protruding in a direction toward the side wall 321 (e.g., the first portion 321a). For example, the support protrusion 345 may be understood as protruding from one side surface of the third camera 343 toward the first portion 321. As will be described below, the first flexible printed circuit board 373 extending from an antenna module (e.g., the antenna module 307 of FIG. 15) may be partially disposed between the side wall 321 and the support protrusion 345, and may be bent to surround at least a portion of the support protrusion 345.

According to an embodiment, the circuit board 364 may be disposed on the support area 322 (or inside the side wall 321) with the extension 364b positioned in an area between the camera assembly 304 and the first portion 321a. For example, between the camera assembly 304 and the first portion 321a, by the contact terminal 364c of the circuit board 364 contacting the contact piece 329, the side wall 321 (e.g., the first portion 321a) may be electrically connected to the extension 364b and/or the circuit board 364 sequentially via the contact piece 329 and the contact terminal 364c.

According to an embodiment, the second portion 321b of the side wall 321 may function as an antenna (e.g., radiator) by being electrically connected to the circuit board 364. For example, the processor 120 and/or communication module 190 of FIG. 1 may be configured to perform wireless communication using the second portion 321b in a frequency band different from the first portion 321a (e.g., about 850 MHz frequency band and/or about 900 MHz frequency band). In an embodiment, in addition to the first portion 321a and the second portion 321b, other conductive portion(s) of the side wall 321 may be electrically connected to the circuit board 364 to perform wireless communication in various frequency bands. In an embodiment, the conductive portions may be electrically insulated from each other while being mechanically connected or coupled by a segmented structure (e.g., the segmented structure 321c of FIG. 14, FIG. 16, and/or FIG. 17). In FIG. 14, the point(s) indicated by reference 'EP' may illustrate point(s) where conductive portion(s) forming the side wall 321 are electrically connected to the circuit board 364 (e.g., feeding point or grounding point).

FIG. 15 is a perspective view illustrating an antenna module of an electronic device according to an embodiment of the disclosure.

Referring to FIG. 15, an antenna module 307 may include an antenna substrate 371 and a first flexible printed circuit board 373 extending from the antenna substrate 371. In an embodiment, the first flexible printed circuit board 373 may be understood as a configuration distinct from the antenna module 307. In an embodiment, the antenna substrate 371 and the first flexible printed circuit board 373 may be substantially implemented as one board, and in this case, the first flexible printed circuit board 373 may be manufactured to be more flexible (or soft) than the antenna substrate 371. The antenna module 307 may be configured to perform, e.g., millimeter wave (mmWave) communication in a frequency band of several tens of GHz or higher. For example, a plurality of radiators implemented in the form of printed circuit patterns may be provided on one surface of the antenna substrate 371, and the electronic device 200 may perform wireless communication in a direction toward which the surface where the radiators are disposed is oriented. It should be noted that in the illustrated embodiment, a structure is illustrated where protective molding is provided on one surface of the antenna substrate 371 to conceal the radiators.

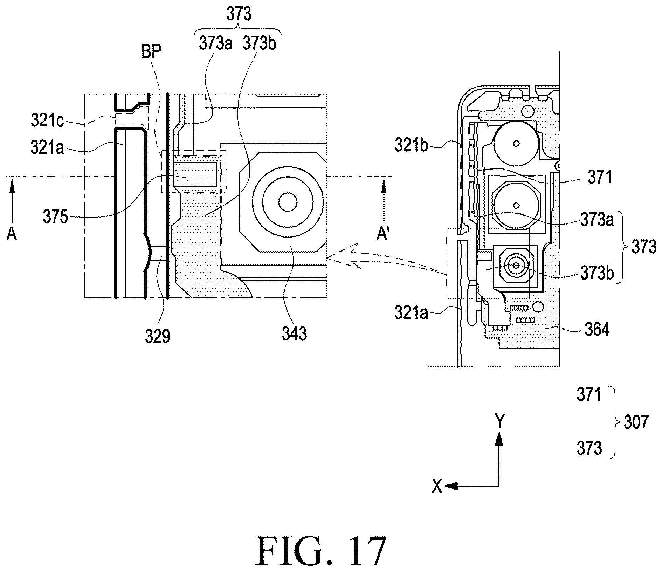

According to an embodiment, the first flexible printed circuit board 373 may be disposed inside the electronic device 200 and/or the housing 320 in a state bent at least once. The first flexible printed circuit board 373 may be described as divided into a first alignment portion 373a between the antenna substrate 371 and the bent portion (e.g., the portion indicated by reference 'BP') and a second alignment portion 373b extending from the first alignment portion 373a. In an embodiment, the first flexible printed circuit board 373 illustrated in FIG. 15 is illustrated as assembled on the housing 320, and in the initial manufactured state, the first flexible printed circuit board 373 may be substantially parallel to the antenna substrate 371. After being bent, the second alignment portion 373b may be disposed to be inclined or substantially perpendicular to the antenna substrate 371 and/or the first alignment portion 373a. In an embodiment, the first flexible printed circuit board 373 may be electrically connected to a circuit board (e.g., the second circuit board 264 of FIG. 4 or the circuit board 364 of FIG. 17) at an end of the second alignment portion 373b.

According to an embodiment, the electronic device 200 and/or the first flexible printed circuit board 373 may further include a first dummy member 375 disposed at the bent portion BP of the first flexible printed circuit board 373. In an embodiment, the first dummy member 375 may be formed of an elastic body, synthetic resin, and/or metal material, and may maintain the shape of the bent portion BP in a design shape. For example, as the first flexible printed circuit board 373 has elastic force, when disposed in a bent shape, it may have a tendency to restore to its initially manufactured shape, and the first dummy member 375 may suppress the restoring force of the first flexible printed circuit board 373 to force it to remain in the bent shape.

According to an embodiment, the first flexible printed circuit board 373 may have different separation distances from surrounding other components (e.g., the side wall 321, the camera assembly 304, and/or the cover plate 299 of FIG. 26) according to its shape. When the first flexible printed circuit board 373 is configured to transmit wireless communication signals, such distance variations may substantially cause variations in wireless communication performance. In an embodiment, the first dummy member 375 may maintain a constant distance from surrounding components by maintaining the first flexible printed circuit board 373 in a design shape at the bent portion BP. For example, the first dummy member 375 may suppress variations in wireless communication performance by making the shape of the first flexible printed circuit board 373 or the distance from surrounding components constant.

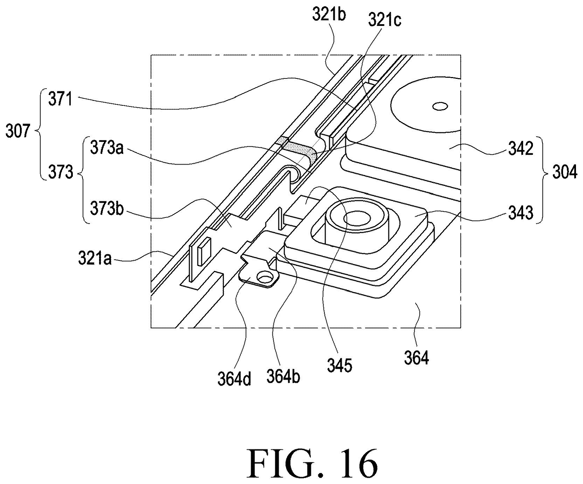

The configuration regarding the antenna module 307 disposed on the housing 320 is examined with further reference to FIGS. 16 to 18.

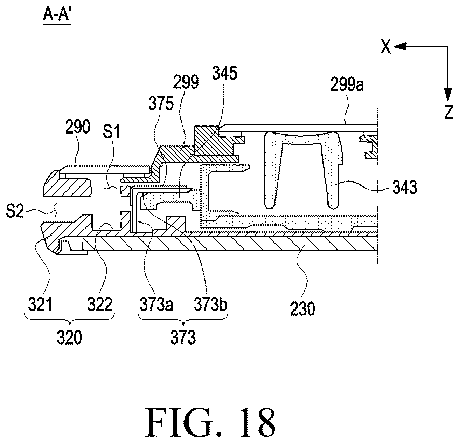

FIG. 16 is a perspective view illustrating a process of disposing the antenna module of FIG. 15 in a housing in an electronic device according to an embodiment of the disclosure. FIG. 17 is a view illustrating the antenna module of FIG. 15 disposed in a housing in an electronic device according to an embodiment of the disclosure. FIG. 18 is a view illustrating a cross-section of a portion of an electronic device according to an embodiment of the disclosure taken along line A-A' of FIG. 17.

Referring further to FIGS. 16 to 18, the antenna module 307 (e.g., the antenna substrate 371) may be disposed between the side wall 321 (e.g., the second portion 321b) and the camera assembly 304, with the surface where the radiators are disposed facing the second portion 321b. In an embodiment, the first flexible printed circuit board 373 may extend from the antenna substrate 371 and be disposed at least partially between the second portion 321b and the camera assembly 304 and/or between the first portion 321a and the camera assembly 304. In an embodiment, one end of the first flexible printed circuit board 373 (e.g., the second alignment portion 373b) may be electrically (or mechanically) connected to the circuit board 364 on one side of the third camera 343. For example, the first flexible printed circuit board 373 may transmit wireless communication signals from a communication circuit (e.g., the communication module 190 of FIG. 1) disposed on the circuit board 364 to the antenna substrate 371. In an embodiment, wireless communication signals received through the antenna substrate 371 may be provided to the circuit board 364 through the first flexible printed circuit board 373.

According to an embodiment, the support protrusion 345 may be disposed between the contact piece 329 (or the contact terminal 364c) and the antenna substrate 371, and the bent portion BP of the first flexible printed circuit board 373 (e.g., the first dummy member 375) may be disposed to surround (to cover at least a portion of) at least a portion of the support protrusion 345. For example, the bent portion BP of the first flexible printed circuit board 373 may be disposed adjacent to (or substantially in contact with) two areas that are inclined or substantially perpendicular to each other among the surfaces of the support protrusion 345. In an embodiment, as illustrated in FIG. 16, a portion of the first flexible printed circuit board 373 (e.g., the first alignment portion 373a) may be disposed between the camera assembly 304 and the side wall 321 (e.g., the first portion 321a and/or the second portion 321b) in a state parallel to the antenna substrate 371. For example, between the bent portion BP and the antenna substrate 371, the first alignment portion 373a may be aligned in a direction facing the side wall 321 together with the antenna substrate 371.

According to an embodiment, from the bent portion BP (e.g., the first dummy member 375) to the end connected to the circuit board 364, another portion of the first flexible printed circuit board 373 (e.g., the second alignment portion 373b) may be bent relative to the first alignment portion 373a to be disposed to be oriented in a direction different from the first alignment portion 373a. For example, when the first alignment portion 373a is disposed to be oriented toward the side wall 321, the second alignment portion 373b may be understood as being disposed to be oriented toward substantially the front surface (e.g., the second front surface 220a of FIG. 2) or the rear surface (e.g., the second rear surface 220b of FIG. 2) of the electronic device 200. In an embodiment, the second alignment portion 373b may be disposed between the camera assembly 304 and the first portion 321a and/or between the camera assembly 304 and the second portion 321b.

According to an embodiment, between the side wall 321 and the camera assembly 304, the first flexible printed circuit board 373 may be disposed to cross an area where the contact piece 329 and/or the contact terminal 364c are disposed. When the contact piece 329, the contact terminal 364c, and/or the first flexible printed circuit board 373 function as transmission lines for wireless communication signals and are disposed adjacent to each other, electromagnetic interference may occur. Electromagnetic interference occurring between transmission lines may reduce the efficiency of wireless communication or distort wireless communication signals. As mentioned above, by being bent at least once, the first flexible printed circuit board 373 may be disposed at a sufficient distance to suppress electromagnetic interference while being allowed in a narrow space. Here, 'a sufficient distance to suppress electromagnetic interference while being allowed in a narrow space' refers to the distance from the contact piece 329 or the contact terminal 364c, and may be a distance allowed in the design specifications of the electronic device 200 or the housing 320.

According to an embodiment, the support protrusion 345 and/or the bent portion BP of the first flexible printed circuit board 373 may be disposed in an area between the contact piece 329 and the antenna substrate 371. For example, the portion of the first flexible printed circuit board 373 that crosses the area where the contact piece 329 or the contact terminal 364c is disposed may be substantially the second alignment portion 373b. In an embodiment, the second alignment portion 373b may be understood as being disposed to face the contact piece 329 (or the contact terminal 364c) with the circuit board 364 (e.g., the extension 364b) interposed therebetween. In an embodiment, when the first alignment portion 373a is disposed to cross the area where the contact piece 329 or the contact terminal 364c is disposed, the first flexible printed circuit board 373 may be disposed quite close to the contact terminal 364c, causing electromagnetic interference. In the embodiment(s) of the disclosure, the arrangement of the contact terminal 364c, the support protrusion 345, and/or the bent portion BP of the first flexible printed circuit board 373 may suppress electromagnetic interference by sufficiently securing the distance between the contact terminal 364c and the first flexible printed circuit board 373 (and/or the distance between the contact piece 329 and the first flexible printed circuit board 373) within the range allowed by the inner space of the electronic device 200. The distance between the contact terminal 364c and the first flexible printed circuit board 373 may be understood as measured along the Y-axis direction from the contact terminal 364c to the first alignment portion 373a in the structure illustrated in FIG. 17, and may be understood as measured along the Z-axis direction from the contact terminal 364c to the second alignment portion 373b in the structure illustrated in FIG. 18.

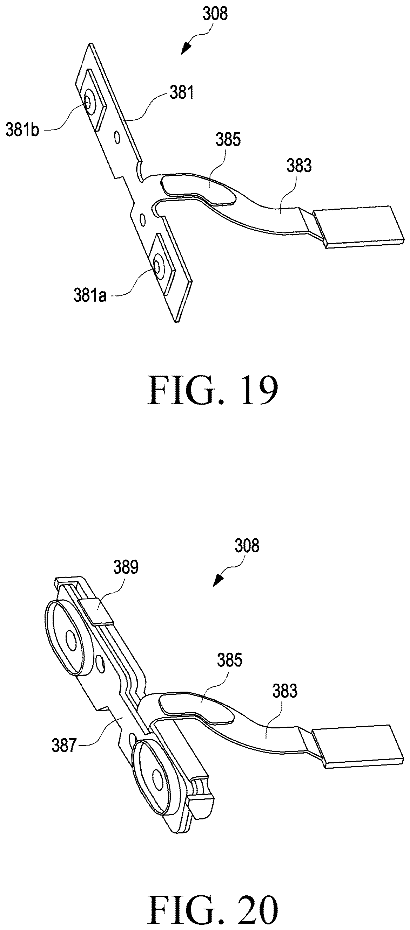

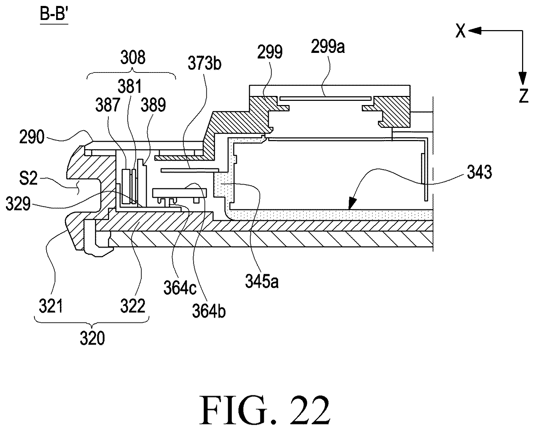

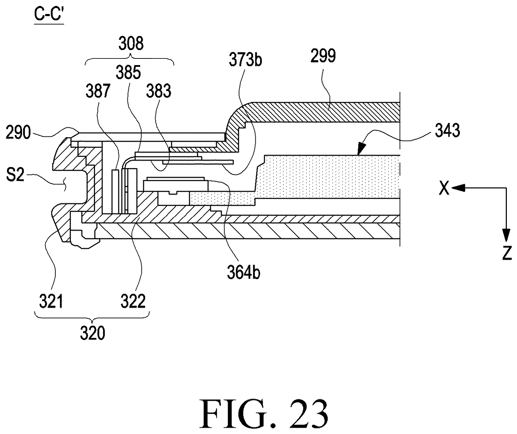

In the structure illustrated in FIG. 18, the area indicated by 'S1' may illustrate a space where a keypad assembly (e.g., the keypad assembly 308 of FIG. 19 or FIG. 20) described below is disposed, and the area indicated by 'S2' may illustrate a space where a key (e.g., the button member 397 of FIG. 24) that a user will operate to actuate the keypad assembly 308 is disposed. Before the key is disposed, the S2 area may be perceived by the user as a groove shape from the outside of the side wall 321. In an embodiment, at portions facing switches (e.g., the switches 381a and 381b of FIG. 19) of the keypad assembly 308 described below, the S2 area may be a through hole structure from the outer surface of the side wall 321 to the S1 area, and at portions not facing the switches, it may have a recess or groove shape as in FIG. 22 or FIG. 23. In an embodiment, the S1 area or S2 area may be understood as being at least partially provided by the first portion 321a of the side wall 321.

The configuration and arrangement of the keypad assembly 308 is examined with further reference to FIGS. 19 to 23.

FIG. 19 is a first perspective view illustrating a keypad assembly of an electronic device according to an embodiment of the disclosure. FIG. 20 is a second perspective view illustrating a keypad assembly of an electronic device according to an embodiment of the disclosure.

First, referring to FIGS. 19 and 20, a keypad assembly 308 may include a switch substrate 381 and a second flexible printed circuit board 383. The switch substrate 381 may include, e.g., at least one switch 381a and 381b disposed on one surface. In an embodiment, the switches 381a and 381b may be implemented with a mechanical structure such as a dome switch or tact switch, and in an embodiment, may be implemented as a capacitive sensor or pressure sensor. In an embodiment, the second flexible printed circuit board 383 extends from the switch substrate 381 and may be electrically connected to the circuit board 364 at its end. In an embodiment, the electronic device 200 and/or the keypad assembly 308 may further include a second dummy member 385 disposed on the second flexible printed circuit board 383, thereby standardizing the arrangement of the second flexible printed circuit board 383 and/or the first flexible printed circuit board 373. In an embodiment, when the second dummy member 385 is positioned at a first distance from the switch substrate 381, it may be understood as being positioned at a second distance greater than the first distance from the end of the second flexible printed circuit board 383.

According to an embodiment, the electronic device 200 and/or the keypad assembly 308 may further include a protective plate 387 disposed on one surface of the switch substrate 381 and a protective bracket 389 disposed on the other surface of the switch substrate 381. As illustrated through FIG. 22 or FIG. 23, when the keypad assembly 308 is disposed on the housing 320, the protective plate 387 protects the switch substrate 381 by being disposed between one surface of the switch substrate 381 and the side wall 321 (e.g., the first portion 321a), and the protective bracket 389 may prevent the other surface of the switch substrate 381 from directly contacting structures of the side wall 321 or the support area 322. For example, the switch substrate 381 may be substantially disposed or fixed inside the side wall 321 by the protective plate 387 and the protective bracket 389. In an embodiment, the protective plate 387 may be formed of an elastic body such as rubber or silicone, thereby providing a waterproof/dustproof structure at the S2 area of the through hole structure or the inner surface of the side wall 321.

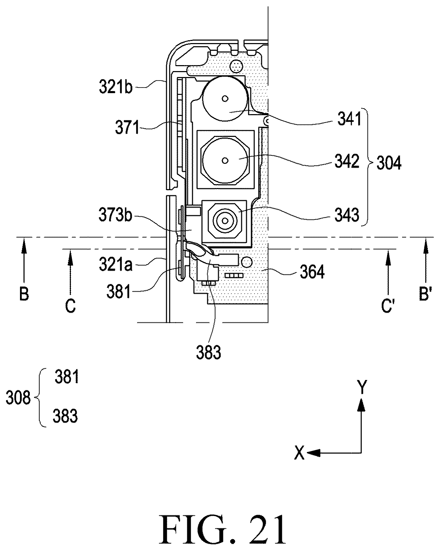

FIG. 21 is a view illustrating the keypad assembly of FIG. 19 or FIG. 20 disposed in a housing in an electronic device according to an embodiment of the disclosure. FIG. 22 is a view illustrating a cross-section of a portion of an electronic device according to an embodiment of the disclosure taken along line B-B' of FIG. 21. FIG. 23 is a view illustrating a cross-section of a portion of an electronic device according to an embodiment of the disclosure taken along line C-C' of FIG. 21.

It should be noted that FIGS. 22 and 23 illustrate a rear plate 290 (e.g., the second rear plate 290 of FIG. 4) or a cover plate 299, but in FIG. 21, the rear plate 290 or cover plate 299 is omitted to illustrate the arrangement of the camera assembly 304, the antenna module 307, and/or the keypad assembly 308.

Referring further to FIGS. 21 to 23, the keypad assembly 308 may be disposed to face the side wall 321 (e.g., the first portion 321a) in the inner space of the housing 320 (e.g., the S1 area of FIG. 18). In an embodiment, 'the keypad assembly 308 being disposed to face the side wall' may refer to the switch substrate 381 or switch(es) 381a and 381b being disposed to face the inner surface of the side wall 321. In an embodiment, the switch substrate 381 may be stably disposed on structures provided by the housing 320 (e.g., the side wall 321 or the support area 322) by the protective plate 387 and/or the protective bracket 389. In an embodiment, the second flexible printed circuit board 383 may be disposed on the circuit board 364 in a bent state with respect to the switch substrate 381. For example, when the switch substrate 381 is disposed to be oriented toward the side wall 321, the second flexible printed circuit board 383 may be understood as being disposed to be oriented toward the front surface (e.g., the second front surface 220a of FIG. 2) or the rear surface (e.g., the second rear surface 220b of FIG. 2) of the electronic device 200.

According to an embodiment, the second flexible printed circuit board 383 may be partially aligned to substantially face the circuit board 364 with the first flexible printed circuit board 373 interposed therebetween, and its end may be electrically (and/or mechanically) connected to the circuit board 364. For example, the second flexible printed circuit board 383 may be disposed to cross (or intersect with) a portion of the first flexible printed circuit board 373 on the circuit board 364. In an embodiment, the first flexible printed circuit board 373 may be understood as being disposed to sequentially cross the area where the contact piece 329 (or the contact terminal 364c) is disposed and the area where the second flexible printed circuit board 383 (or the second dummy member 385) is disposed, and connected to the circuit board 364 at its end.

According to an embodiment, when the circuit board 364 is disposed on the housing 320 (e.g., the support area 322), the contact terminal 364c and the contact piece 329 may be mechanically and/or electrically contacted. As the contact terminal 364c deforms and accumulates elastic force in the contact state with the contact piece 329, the contact state may be maintained more stably. In an embodiment, the elastic force accumulated in the contact terminal 364c may press the circuit board 364 (e.g., the extension 364b) in the -Z direction. When elastic force of the contact terminal 364c acts in a structure in which the extension 364b has a considerably small length or width (e.g., length or width within several mm), the extension 364b may be deformed or damaged. In an embodiment, the support plate 364d of FIG. 13 or FIG. 14 supports the extension 364b from the other surface of the extension 364b, thereby suppressing deformation of the extension 364b by the elastic force of the contact terminal 364c while maintaining the contact state between the contact terminal 364c and the contact piece 329 more stably.

According to an embodiment, the rear plate 290 may provide a through hole structure at a position corresponding to the camera assembly 304, thereby providing a capturing path or optical path of the camera assembly 304. In an embodiment, to protect the camera assembly 304, the electronic device 200 and/or the rear plate 290 may further include a cover plate 299. In an embodiment, the cover plate 299 may be understood as being a portion of the rear plate 290.

According to an embodiment, the cover plate 299 may be disposed on at least a portion around the camera assembly 304 and may provide optical hole(s) at positions corresponding to the cameras 341, 342, and 343. In the illustrated embodiment, a structure in which a window plate 399a is disposed in the optical hole(s) of the cover plate 299 may be illustrated. In an embodiment, at least a portion of the edge of the cover plate 299 may be attached or fixed to the inner surface of the rear plate 290, and at least a portion of the outer surface may be exposed to the outside of the rear plate 290. In an embodiment, to harmonize with the appearance of the electronic device 200 and/or the rear plate 290, or to enhance aesthetics in the appearance of the electronic device 200, the cover plate 299 may be formed of a metal material or finished with a metal material (e.g., printing, coating, deposition, or plating).

According to an embodiment, on the circuit board 364 or inside the rear plate 290, the second dummy member 385 may be disposed to at least partially face or contact the inner surface of the cover plate 299. For example, the second dummy member 385 may maintain a gap between the second flexible printed circuit board 383 and the cover plate 299. In an embodiment, the first flexible printed circuit board 373 may be disposed to overlap the second flexible printed circuit board 383 in the area where the second dummy member 385 is disposed. For example, by providing the second dummy member 385 and the second flexible printed circuit board 383, the first flexible printed circuit board 373 may be disposed on the circuit board 364 (e.g., the extension 364b of FIGS. 12 to 14) in a design shape and positioned at a designated distance from the rear plate 290 and/or the cover plate 299.

According to an embodiment, the camera assembly 304, e.g., the third camera 343, may further include a flange portion 345a connected to the support protrusion 345 on the surface where the support protrusion 345 is provided among the outer surface periphery. In an embodiment, the support protrusion 345 may be understood as a portion of the flange portion 345a, and may have a structure that protrudes more than the rest of the flange portion 345a at a position corresponding to the bent portion BP of the first flexible printed circuit board 373 among the flange portion 345a. From the bent portion BP to the end connected to the circuit board 364, a portion of the first flexible printed circuit board 373 (e.g., the second alignment portion 373b) may be positioned at a designated distance from the rear plate 290 and/or the cover plate 299 while maintaining a design shape by being supported by the flange portion 345a.

According to an embodiment, when the first flexible printed circuit board 373 functions as a transmission line for analog signals (e.g., wireless communication signals), induced currents may occur in surrounding conductive structures. When induced currents occur, the efficiency of signal transmission may decrease or the quality of wireless communication may deteriorate due to distortion of transmission signals. By providing various forms of electromagnetic shielding structures, such generation of induced currents or electromagnetic interference may be suppressed. In an embodiment, by providing the second dummy member 385 and the second flexible printed circuit board 383, the first flexible printed circuit board 373 is positioned at a designated distance from the rear plate 290 and/or the cover plate 299, thereby suppressing the generation of induced currents.

In an embodiment, when the first flexible printed circuit board 373 in the form of a thin film is disposed differently from the design shape, variations may occur in the wireless communication performance of different electronic devices manufactured to the same specifications. In the embodiment(s) of the disclosure, by disposing the first flexible printed circuit board 373 in a design shape using the support protrusion 345, the flange portion 345a, and/or the dummy members 375 and 385, deterioration of wireless communication performance or variations in wireless communication performance may be suppressed even when structures including metal materials or conductive materials (e.g., the cover plate 299) are disposed adjacently.

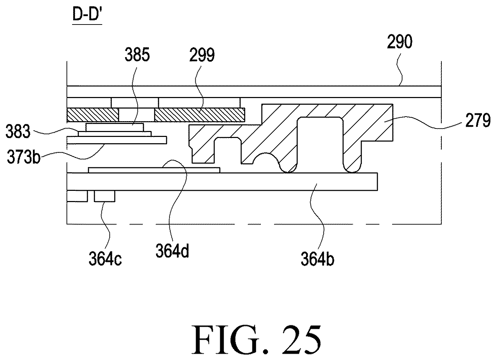

FIG. 24 is a view illustrating flexible printed circuit board(s) disposed in an electronic device according to an embodiment of the disclosure. FIG. 25 is a view illustrating a cross-section of a portion of an electronic device according to an embodiment of the disclosure taken along line D-D' of FIG. 24.

Referring to FIGS. 24 and 25, the rear member 270 of FIG. 4 may stably maintain the arrangement structure or connection state of various components within the housing 320. For example, in the rear member 270, the support portion indicated by reference '279' and/or other portion(s) may support a portion of the circuit board 364 or support the ends of the first flexible printed circuit board 373 and/or the second flexible printed circuit board 383 to stably maintain the state connected to the circuit board 364. In an embodiment, although reference numbers are not given, the support portion 279 may be disposed to directly contact the circuit board 364 or the support plate 364d through protrusions formed on the surface facing the circuit board 364. Thus, the circuit board 364 may be stably fixed by the support area 322 and the rear member 270, and deformation or damage of the extension 364b may be suppressed.

According to an embodiment, a button member 397 may be disposed in the S2 area of FIG. 18, FIG. 22, and/or FIG. 23, and may protrude by a designated height from the outer surface of the side wall 321 (e.g., the first portion 321a). The height that the button member 397 protrudes from the outer surface of the side wall 321 may be determined, e.g., by the movement distance of the button member 397 that may actuate the switch(es) 381a and 381b of the keypad assembly 308.

FIG. 26 is a first view illustrating a cover plate disposed in an electronic device according to an embodiment of the disclosure. FIG. 27 is a second view illustrating a cover plate disposed in an electronic device according to an embodiment of the disclosure.

Referring to FIGS. 26 and 27, as previously examined, when a line through which analog signals are transmitted (e.g., the first flexible printed circuit board 373 of FIG. 15 and/or FIGS. 22 to 25) is disposed adjacent to a conductive structure such as the cover plate 299, induced currents or electromagnetic interference may occur to deteriorate wireless communication performance. In the embodiment(s) of the disclosure, to suppress electromagnetic interference that may occur between the first flexible printed circuit board 373 and conductive structures, the second flexible printed circuit board 383 may be disposed between the first flexible printed circuit board 373 and the cover plate 299, and the second dummy member 385 may be disposed between the second flexible printed circuit board 383 and the cover plate 299 and/or between the first flexible printed circuit board 373 and the cover plate 299. For example, by providing a designated gap between the first flexible printed circuit board 373 and the cover plate 299, electromagnetic interference between the first flexible printed circuit board 373 and the cover plate 299 may be suppressed.

According to an embodiment, by reducing the area where the first flexible printed circuit board 373 and the cover plate 299 face each other (or overlap), electromagnetic interference or generation of induced currents between the first flexible printed circuit board 373 and the cover plate 299 may be suppressed. In an embodiment, the cover plate 299 may provide a notch portion 299b extending inward from one edge. The notch portion 299b is, e.g., implemented by removing a portion of the cover plate 299, and may be disposed at a position overlapping the second dummy member 385, the first flexible printed circuit board 373, and/or the second flexible printed circuit board 383. In an embodiment, the second dummy member 385 may be understood as being disposed at least partially between the notch portion 299b and the first flexible printed circuit board 373, or between the notch portion 299b and the second flexible printed circuit board 383.

According to an embodiment, the notch portion 299b may be understood as being implemented by providing a protrusion 299c on one edge of the cover plate 299. For example, the protrusion 299c may be implemented to surround at least a portion of the notch portion 299b by extending from one side of the cover plate 299 toward the outside of the cover plate 299. In an embodiment, the protrusion 299c may be disposed in an area that does not substantially overlap the second dummy member 385, the first flexible printed circuit board 373, and/or the second flexible printed circuit board 383.

According to an embodiment, the second dummy member 385 may be manufactured to a designated size and disposed at a designated position on the second flexible printed circuit board 383. In an embodiment, one end of the second flexible printed circuit board 383 may be understood as being connected to the switch substrate 381, and the other end may be directly coupled to the circuit board 364. In this case, due to the height difference between the switch substrate 381 and the circuit board 364, a portion of the second flexible printed circuit board 383 may be disposed in an inclined or curved shape on the circuit board 364. The partial inclination or curvature of the second flexible printed circuit board 383 may increase closer to the switch substrate 381 or closer to the connection portion with the circuit board 364. In an embodiment, the second dummy member 385 may be disposed at a portion where such inclination or curvature of the second flexible printed circuit board 383 is relatively small. In an embodiment, the second dummy member 385 may be understood to be disposed closer to the switch substrate 381 between the end of the second flexible printed circuit board 383 and the switch substrate 381.

According to an embodiment, the second flexible printed circuit board 383 may be bent at a designated angle (e.g., about 90 degrees) at a portion adjacent to the switch substrate 381, form a gentle inclination between the circuit board 364 and the cover plate 299, and be connected to the circuit board 364 at the end. In an embodiment, the area of the second flexible printed circuit board 383 where the second dummy member 385 is disposed may be disposed substantially parallel to the circuit board 364 or the cover plate, and the area of the second flexible printed circuit board 383 between the second dummy member 385 and the portion connected to the circuit board 364 may be disposed to be inclined relative to the circuit board 364 or disposed in a curved form.

As described above, by suppressing shape changes of transmission line while an antenna module (e.g., the antenna module 307 of FIGS. 15 to 17) is disposed in a narrow space, an electronic device (e.g., the electronic device 101, 200 of FIGS. 1 to 4) may be provided with a stable wireless communication environment. In an embodiment, by disposing a plurality of antennas within one housing (e.g., the second housing 220 of FIGS. 2 to 4 or the housing 320 of FIG. 14), shape changes of antenna transmission line may be suppressed even in a structure including a plurality of housings. For example, in an electronic device including a plurality of housings, variations in wireless communication performance due to relative positions of the housings or shape changes of transmission line may be suppressed.

Effects of the disclosure are not limited to the foregoing, and other unmentioned effects would be apparent to one of ordinary skill in the art from the description of the foregoing embodiment(s).

According to an embodiment of the disclosure, an electronic device (e.g., the electronic device 101, 200 of FIGS. 1 to 4) may include a housing (e.g., the second housing 220 of FIGS. 2 to 4 or the housing 320 of FIG. 14) including a front surface (e.g., the second front surface 220a of FIG. 2), a rear surface (e.g., the second rear surface 220b of FIG. 2) facing a direction opposite to the front surface, and a side wall (e.g., the second side wall 221 of FIG. 4 or the side wall 321 of FIG. 14) at least partially surrounding a space between the front surface and the rear surface, a camera assembly (e.g., the camera assembly 204, 304 of FIG. 4, FIG. 7, FIG. 10 and/or FIG. 14) disposed at one edge of the space, adjacent to the side wall, a support protrusion (e.g., the support protrusion 345 of FIG. 10, FIG. 11 and/or FIG. 14) protruding from the camera assembly in a direction, a first radiator disposed as at least a portion of a first portion (e.g., the first portion 321a of FIG. 14) of the side wall adjacent to the camera assembly and configured to perform wireless communication in a first frequency band, an antenna module (e.g., the antenna module 307 of FIGS. 15 to 17) at least partially disposed between a second portion (e.g., the second portion 321b of FIG. 14) of the side wall adjacent to the first portion and the camera assembly, the antenna module configured to perform wireless communication in a second frequency band, and a first flexible printed circuit board (e.g., the first flexible printed circuit board 373 of FIGS. 15 to 17) extending from the antenna module and disposed at least partially between the first portion and the camera assembly. In an embodiment, the first flexible printed circuit board may be disposed to surround or cover two areas on a surface of the support protrusion disposed to be inclined or perpendicular with respect to each other (see FIG. 18).

According to an embodiment, the electronic device as described above may further include a segmented structure (e.g., the segmented structure 321c of FIG. 14, FIG. 16 and/or FIG. 17) disposed between the first portion and the second portion, and a second radiator disposed as at least a portion of the second portion and configured to perform wireless communication in a third frequency band.

According to an embodiment, the antenna module may include an antenna substrate (e.g., the antenna substrate 371 of FIG. 15) disposed at least partially between the second portion and the camera assembly. In an embodiment, the first flexible printed circuit board may extend from the antenna substrate.

According to an embodiment, by the first flexible printed circuit board being bent at least once around the support protrusion, a portion of the first flexible printed circuit board (e.g., the first alignment portion 373a of FIG. 15) may be aligned in a direction facing the side wall between the second portion and the camera assembly or between the first portion and the camera assembly. In an embodiment, another portion of the first flexible printed circuit board (e.g., the second alignment portion 373b of FIG. 15) may be aligned in a direction facing the front surface or the rear surface between the first portion and the camera assembly.

According to an embodiment, the electronic device as described above may further include a first dummy member (e.g., the first dummy member 375 of FIG. 15) disposed at a bent portion of the first flexible printed circuit board.

According to an embodiment, the electronic device as described above may further include a circuit board (e.g., the second circuit board 264 of FIG. 4 and/or the circuit board 364 of FIGS. 12 to 14) disposed in the space between the front surface and the rear surface and providing an opening area (e.g., the opening area 364a of FIG. 12 and/or FIG. 13) receiving a portion of the camera assembly, an extension (e.g., the extension 364b of FIGS. 12 to 14) as a portion of the circuit board and defining a portion of the opening area, the extension disposed at least partially between the first portion and the camera assembly, and a contact piece (e.g., the contact piece 329 of FIG. 8, FIG. 9 and/or FIG. 14) extending from the side wall at the first portion and disposed at least partially to face the extension.

According to an embodiment, the electronic device as described above may further include a contact terminal (e.g., the contact terminal 364c of FIG. 12 or FIG. 22) disposed on one surface of the extension and electrically connected to the contact piece. In an embodiment, the first radiator may be configured to receive a power supply signal through the contact terminal and the contact piece.

According to an embodiment, the electronic device as described above may further include a support plate (e.g., the support plate 364d of FIG. 13 or FIG. 14) disposed at least partially on the other surface of the extension, and a fastening hole (e.g., the fastening hole 364e of FIG. 12 or FIG. 13) formed to penetrate the circuit board and the support plate in an area adjacent to the extension.

According to an embodiment, the electronic device as described above may further include a supporting member (e.g., the rear member 270 of FIG. 4, or the support portion 279 of FIG. 4, FIG. 24, FIG. 25) disposed between the rear surface and the circuit board. In an embodiment, the supporting member may be configured to support the circuit board or the one surface of the extension.

According to an embodiment, the electronic device as described above may further include a keypad assembly (e.g., the keypad assembly 308 of FIGS. 19 to 24) disposed at least partially between the first portion and the camera assembly. In an embodiment, the keypad assembly may include a switch substrate (e.g., the switch substrate 381 of FIG. 19) disposed at least partially between the first portion and the camera assembly, and a second flexible printed circuit board (e.g., the second flexible printed circuit board 383 of FIG. 19) extending from the switch substrate and connected to the circuit board on one side of the camera assembly.

According to an embodiment, the electronic device as described above may further include a cover plate (e.g., the cover plate 299 of FIG. 4, FIG. 22, FIG. 23, FIG. 26 and/or FIG. 27) disposed on at least a portion of a circumference of the camera assembly on the rear surface and a second dummy member (e.g., the second dummy member 385 of FIG. 19 or FIG. 20) disposed on the second flexible printed circuit board. In an embodiment, the second dummy member may be disposed to face the cover plate.

According to an embodiment, at least a portion of the first flexible printed circuit board may be disposed between the circuit board and the second dummy member.

According to an embodiment, the cover plate may include a notch portion (e.g., the notch portion 299b of FIG. 26) extending inward from one edge.

According to an embodiment, the notch portion may be disposed to at least partially overlap the second dummy member.

According to an embodiment, the electronic device as described above may further include a second housing (e.g., the first housing 210 of FIGS. 2 to 4), a hinge structure (e.g., the hinge assembly 202 of FIG. 4) configured to rotatably couple the second housing to the housing and provide at least one folding axis as a rotation center of the housing or the second housing, and a flexible printed circuit board (e.g., the flexible printed circuit board 266 of FIG. 4, FIG. 5 and/or FIG. 7) disposed from an inside of the housing across the hinge structure to an inside of the second housing.

According to an embodiment, the electronic device as described above may further include a flexible display (e.g., the flexible display 230 of FIG. 2 or FIG. 4) including a first display area (e.g., the first display area 231 of FIG. 2 or FIG. 4) disposed in one of the housing and the second housing, a second display area (e.g., the second display area 232 of FIG. 2 or FIG. 4) disposed in the other of the housing and the second housing, and a folding area (e.g., the folding area 233 of FIG. 2 or FIG. 4) disposed on the hinge structure. In an embodiment, the flexible display may be configured to output a screen through at least a portion of the front surface of the housing.

According to an embodiment of the disclosure, an electronic device (e.g., the electronic device 101, 200 of FIGS. 1 to 4) may include a first housing (e.g., the first housing 210 of FIGS. 2 to 4), a second housing (e.g., the second housing 220 of FIGS. 2 to 4 or the housing 320 of FIG. 14), a hinge structure (e.g., the hinge assembly 202 of FIG. 4) configured to rotatably couple the first housing and the second housing and provide at least one folding axis (e.g., the folding axis A of FIG. 2 or FIG. 4) as a rotation center of the first housing or the second housing, a flexible printed circuit board (e.g., the flexible printed circuit board 266 of FIG. 4, FIG. 5 and/or FIG. 7) disposed from an inside of the first housing across the hinge structure to an inside of the second housing, a flexible display (e.g., the flexible display 230 of FIG. 2 or FIG. 4) including a first display area (e.g., the first display area 231 of FIG. 2 or FIG. 4), a second display area (e.g., the second display area 232 of FIG. 2 or FIG. 4), and a folding area (e.g., the folding area 233 of FIG. 2 or FIG. 4) connecting the first display area to the second display area and disposed on the hinge structure, a camera assembly (e.g., the camera assembly 204, 304 of FIG. 4, FIG. 7, FIG. 10 and/or FIG. 14) disposed at one edge inside one of the first housing and the second housing, adjacent to a side wall (e.g., the second side wall 221 of FIG. 4 or the side wall 321 of FIG. 14), a first radiator as a first portion (e.g., the first portion 321a of FIG. 14) of the side wall at least partially disposed adjacent to the camera assembly and configured to perform wireless communication in a first frequency band, an antenna module (e.g., the antenna module 307 of FIGS. 15 to 17) including an antenna substrate (e.g., the antenna substrate 371 of FIG. 15) at least partially disposed between a second portion (e.g., the second portion 321b of FIG. 14) of the side wall adjacent to the first portion and the camera assembly, the antenna module configured to perform wireless communication in a second frequency band, and a second radiator as at least a portion of the second portion and configured to perform wireless communication in a third frequency band. In an embodiment, the antenna module may include a first flexible printed circuit board (e.g., the first flexible printed circuit board 373 of FIGS. 15 to 17) disposed at least partially between the first portion and the camera assembly.

According to an embodiment, the electronic device as described above may further include a circuit board (e.g., the second circuit board 264 of FIG. 4 and/or the circuit board 364 of FIGS. 12 to 14) providing an opening area (e.g., the opening area 364a of FIG. 12 and/or FIG. 13) receiving a portion of the camera assembly, an extension (e.g., the extension 364b of FIGS. 12 to 14) as a portion of the circuit board and defining a portion of the opening area, the extension disposed at least partially between the first portion and the camera assembly, a contact piece (e.g., the contact piece 329 of FIG. 8, FIG. 9 and/or FIG. 14) extending from the side wall at the first portion and disposed at least partially to face the extension, and a contact terminal (e.g., the contact terminal 364c of FIG. 12 or FIG. 22) disposed on one surface of the extension and electrically connected to the contact piece. In an embodiment, the first radiator may be configured to receive a power supply signal through the contact terminal and the contact piece.

According to an embodiment, the first flexible printed circuit board may be disposed to face the contact piece with the extension interposed therebetween.

According to an embodiment, the electronic device as described above may further include a keypad assembly (e.g., the keypad assembly 308 of FIGS. 19 to 24) disposed at least partially between the first portion and the camera assembly. In an embodiment, the keypad assembly may include a switch substrate (e.g., the switch substrate 381 of FIG. 19) disposed at least partially between the first portion and the camera assembly, and a second flexible printed circuit board (e.g., the second flexible printed circuit board 383 of FIG. 19) extending from the switch substrate, disposed to cross the first flexible printed circuit board, and connected to the circuit board on one side of the camera assembly.

According to an embodiment, a portion of the first flexible printed circuit board may be disposed between the circuit board and the second flexible printed circuit board.

According to an embodiment of the disclosure, an electronic device (e.g., the electronic device 101, 200 of FIGS. 1 to 4) includes a housing (e.g., the second housing 220 of FIGS. 2 to 4 or the housing 320 of FIG. 14) including a front surface (e.g., the second front surface 220a of FIG. 2), a rear surface (e.g., the second rear surface 220b of FIG. 2) facing a direction opposite to the front surface, and a side wall (e.g., the second side wall 221 of FIG. 4 or the side wall 321 of FIG. 14) at least partially surrounding a space between the front surface and the rear surface, a camera assembly (e.g., the camera assembly 204, 304 of FIG. 4, FIG. 7, FIG. 10 and/or FIG. 14) disposed at one edge of the space, adjacent to the side wall, a cover plate (e.g., the cover plate 299 of FIG. 4, FIG. 22, FIG. 23, FIG. 26 and/or FIG. 27) disposed on at least a portion around the camera assembly and at least partially exposed to the outside through the rear surface, a keypad assembly (e.g., the keypad assembly 308 of FIGS. 19 to 24) disposed at least partially between a first portion of the side wall adjacent to the camera assembly and the camera assembly, and an antenna module (e.g., the antenna module 307 of FIGS. 15 to 17) having a portion disposed between a second portion of the side wall adjacent to the first portion and the camera assembly, the antenna module including a first flexible printed circuit board (e.g., the first flexible printed circuit board 373 of FIGS. 15 to 17) disposed at least partially between the first portion and the camera assembly. In an embodiment, the keypad assembly may include a switch substrate (e.g., the switch substrate 381 of FIG. 19) disposed at least partially between the first portion and the camera assembly, a second flexible printed circuit board (e.g., the second flexible printed circuit board 383 of FIG. 19) extending from the switch substrate and disposed to intersect with the first flexible printed circuit board on one side of the camera assembly, and a dummy member (e.g., the second dummy member 385 of FIG. 19 or FIG. 20) disposed on the second flexible printed circuit board in a state at least partially facing the cover plate.

According to an embodiment, the cover plate may provide a notch portion (e.g., the notch portion 299b of FIG. 26) at least partially surrounded by a protrusion (e.g., the protrusion 299c of FIG. 26) extending from one side of an edge toward the outside of the cover plate. In an embodiment, a portion of the dummy member may be disposed between the notch portion and the first flexible printed circuit board, or between the notch portion and the second flexible printed circuit board.

According to an embodiment, a portion of the second flexible printed circuit board may be disposed between the first flexible printed circuit board and the cover plate.

According to an embodiment, the electronic device as described above may further include a processor (e.g., the processor 120 of FIG. 1) or a communication module (e.g., the communication module 190 of FIG. 1) configured to perform wireless communication using the first portion, the second portion and/or the antenna module.

According to an embodiment, the side wall may include a segmented structure (e.g., the segmented structure 321c of FIG. 14, FIG. 16 and/or FIG. 17) disposed between the first portion and the second portion.

According to an embodiment, the electronic device as described above may further include a circuit board (e.g., the second circuit board 264 of FIG. 4 and/or the circuit board 364 of FIGS. 12 to 14) disposed in the space between the front surface and the rear surface and providing an opening area (e.g., the opening area 364a of FIG. 12 and/or FIG. 13) receiving a portion of the camera assembly. In an embodiment, an end of the second flexible printed circuit board may be connected to the circuit board.

According to an embodiment, the dummy member may be disposed at a first distance from the switch substrate and positioned at a second distance from the end of the second flexible printed circuit board. In an embodiment, the first distance may be smaller than the second distance.

According to an embodiment, the electronic device as described above may further include an extension (e.g., the extension 364b of FIGS. 12 to 14) as a portion of the circuit board and defining a portion of the opening area, the extension disposed at least partially between the first portion and the camera assembly. In an embodiment, the dummy member may be disposed between the extension and the cover plate.

According to an embodiment, the electronic device as described above may further include a contact piece (e.g., the contact piece 329 of FIG. 8, FIG. 9 and/or FIG. 14) extending from the side wall at the first portion and disposed at least partially to face the extension. In an embodiment, the first portion may be electrically connected to the circuit board through the contact piece.

According to an embodiment, the first flexible printed circuit board may be disposed to sequentially cross an area where the contact piece is disposed and an area where the second flexible printed circuit board is disposed, and an end of the first flexible printed circuit board may be connected to the circuit board.

According to an embodiment, the extension may be disposed at least partially between the contact piece and the first flexible printed circuit board.

According to an embodiment, the electronic device as described above may further include a contact terminal (e.g., the contact terminal 364c of FIG. 12 or FIG. 22) disposed on one surface of the extension and electrically connected to the contact piece. In an embodiment, the first portion may be configured to receive a power supply signal through the contact terminal and the contact piece.

While the disclosure has been described and shown in connection with an embodiment thereof, it should be appreciated that an embodiment is intended not as limiting the invention but as illustrative. It will be apparent to one of ordinary skill in the art that various changes may be made in form and detail without departing from the overall scope of the disclosure, including the appended claims and their equivalents.

## Claims

1. An electronic device (101, 200), comprising:
a housing (220; 320) including a front surface (220a), a rear surface (220b) facing a direction opposite to the front surface, and a side wall (221; 321) at least partially surrounding a space between the front surface and the rear surface;
a camera assembly (204; 304) disposed at one edge of the space, adjacent to the side wall;
a support protrusion (345) protruding from the camera assembly along a direction;
a first radiator configured to perform wireless communication in a first frequency band and disposed as at least a portion of a first portion (321a) of the side wall adjacent to the camera assembly;
an antenna module (307) at least partially disposed between a second portion (321b) of the side wall adjacent to the first portion and the camera assembly, and configured to perform wireless communication in a second frequency band; and
a first flexible printed circuit board (373) extending from the antenna module and disposed at least partially between the first portion and the camera assembly,
wherein the first flexible printed circuit board is disposed to surround or cover two areas on a surface of the support protrusion disposed to be inclined or perpendicular with respect to each other.

2. The electronic device of claim 1, further comprising:
a segmental structure (321c) disposed between the first portion and the second portion; and
a second radiator disposed as at least a portion of the second portion and configured to perform wireless communication in a third frequency band.

3. The electronic device of claim 1 or 2, wherein the antenna module includes an antenna substrate (371) disposed at least partially between the second portion and the camera assembly, and
wherein the first flexible printed circuit board extends from the antenna substrate.

4. The electronic device of claim 3, wherein the first flexible printed circuit board is bent at least once around the support protrusion,
so that a portion of the first flexible printed circuit board is aligned in a direction facing the side wall between the second portion and the camera assembly or between the first portion and the camera assembly, and
another portion of the first flexible printed circuit board is aligned in a direction facing the front surface or the rear surface between the first portion and the camera assembly.

5. The electronic device of claim 4, further comprising:
a first dummy member (375) disposed at a bent portion of the first flexible printed circuit board.

6. The electronic device of any one of claims 1 to 5, further comprising:
a circuit board (364) disposed in the space between the front surface and the rear surface and providing an opening area (364a) for accommodating a portion of the camera assembly;
an extending portion (364b) at least partially disposed between the first portion and the camera assembly, wherein the extending portion is a portion of the circuit board and defines a portion of the opening area; and
a contact piece (329) extending from the side wall at the first portion and at least partially disposed to face the extending portion.

7. The electronic device of claim 6, further comprising:
a contact terminal (364c) disposed on one surface of the extending portion and electrically connected to the contact piece,
wherein the first radiator is configured to receive a power supply signal through the contact terminal and the contact piece.

8. The electronic device of claim 7, further comprising:
a support plate (364d) disposed at least partially on another surface of the extending portion; and
a fastening hole (364e) formed to penetrate the circuit board and the support plate in an area adjacent to the extending portion.

9. The electronic device of any one of claims 6 to 8, further comprising:
a support member (270, 279) disposed between the rear surface and the circuit board,
wherein the support member is configured to support the circuit board or the one surface of the extending portion.

10. The electronic device of any one of claims 6 to 9, further comprising:
a keypad assembly (308) at least partially disposed between the first portion and the camera assembly,
wherein the keypad assembly includes:
a switch substrate (381) at least partially disposed between the first portion and the camera assembly; and
a second flexible printed circuit board (383) extending from the switch substrate and connected to the circuit board on one side of the camera assembly.

11. The electronic device of claim 10, further comprising:
a cover plate (299) disposed at least a portion of a circumference of the camera assembly on the rear surface; and
a second dummy member (385) disposed on the second flexible printed circuit board,
wherein the second dummy member is disposed to face the cover plate.

12. The electronic device of claim 11, wherein at least a portion of the first flexible printed circuit board is disposed between the circuit board and the second dummy member.

13. The electronic device of any one of claims 11 to 12, wherein the cover plate includes a notch portion (299b) extending from one edge of the cover plate toward an inside of the cover plate, and
wherein the notch portion is at least partially overlapped with the second dummy member.

14. The electronic device of any one of claims 1 to 13, further comprising:
a second housing;
a hinge structure (202) configured to rotatably couple the second housing to the housing and providing at least one folding axis (A) as a rotation center of the housing or the second housing; and
a flexible printed circuit board (266) disposed from an inside of the housing to an inside of the second housing across the hinge structure.

15. The electronic device of claim 14, further comprising:
a flexible display including a first display area (231) disposed in one of the housing and the second housing, a second display area (232) disposed in the other of the housing and the second housing, and a folding area (233) disposed on the hinge structure,
wherein the flexible display is configured to output a screen through at least a portion of the front surface of the housing.
